# EUROPÄISCHE PATENTSCHRIFT

(11) **EP 0 920 060 B1**
(45) Veröffentlichungstag und Bekanntmachung des Hinweises auf die Patenterteilung: **20.08.2008**
(21) Anmeldenummer: 98121589.0
(22) Anmeldetag: 19.11.1998
(51) Int. Cl.: H01L 27/11, H01L 21/8244, G11C 11/40

(54) **SRAM-Zellenanordnung und Verfahren zu deren Herstellung**
SRAM cell array and fabrication process thereof
Réseau de cellules SRAM et méthode de fabrication

(30) Priorität: 27.11.1997 DE 19752624
(43) Veröffentlichungstag der Anmeldung: 02.06.1999
(73) Patentinhaber: Infineon Technologies AG, 81669 München (DE)
(72) Erfinder: Schulz, Thomas, 44577 Castrop-Rauxel (DE); Aeugle, Thomas, Dr., 81735 München (DE); Rösner, Wolfgang, Dr., 81739 München (DE); Risch, Lothar, Dr., 85579 Neubiberg (DE)
(74) Vertreter: Patentanwaltskanzlei WILHELM & BECK

(56) Entgegenhaltungen:
- EP-A- 0 477 995
- US-A- 5 364 810
- US-A- 5 394 358

## Beschreibung

Die Erfindung betrifft eine SRAM-Zellenanordnung, bei der eine Speicherzelle mindestens sechs Transistoren umfaßt, sowie ein Verfahren zu deren Herstellung.

Eine SRAM-Zellenanordnung ist eine Speicherzellen-Anordnung mit wahlfreiem Zugriff auf gespeicherte Informationen. Im Gegensatz zu einer DRAM-Zellenanordnung, in der die Information in regelmäßigen Zeitabständen aufgefrischt werden muß, wird die Information statisch gespeichert.

In SRAM-Zellenanordnungen werden zunehmend sogenannte 6 T-Speicherzellen, d.h. Speicherzellen mit sechs Transistoren eingesetzt. Eine 6 T-Speicherzelle umfaßt vier, als Flip-Flop verschaltete MOS-Transistoren und zwei Auswahltransistoren. Der Flip-Flop ist in einem von zwei stabilen Zuständen. Der Zustand des Flip-Flops stellt eine logische Größe, 0 oder 1, dar. Durch Ansteuerung der Auswahltransistoren über eine Wortleitung können über zwei Bitleitungen sowohl der Zustand bestimmt und damit die Information ausgelesen als auch der Zustand verändert und damit eine neue Information gespeichert werden.

Da von Speichergeneration zu Speichergeneration die Speicherdichte zunimmt, muß die benötigte Fläche der 6 T-Speicherzelle von Generation zu Generation reduziert werden.

In Semiconductor International (Nov. 1996) Seite 19 und 20 wird eine 6T-Speicherzelle vorgestellt, die mit einer Fläche von 55F² herstellbar ist, wobei F die minimale in der jeweiligen Technologie herstellbare Strukturgröße ist. Es werden selbstjustierte, d.h. ohne Einsatz von zu justierenden Masken hergestellte, Kontakte sowie lokale Verbindungen, d.h. Verbindungen, die innerhalb der Zelle liegen, eingesetzt.

Der Erfindung liegt das Problem zugrunde, eine SRAM-Zellenanordnung anzugeben, die als Speicherzellen 6 T-Speicherzellen umfaßt und mit im Vergleich zum Stand der Technik erhöhter Packungsdichte herstellbar ist. Ferner soll ein Herstellungsverfahren für eine solche SRAM-Zellenanordnung angegeben werden.

Eine SRAM-Zellenanordnung mit den Merkmalen des Oberbegriffs des Anspruchs 1 und ein entsprechendes Herstellungsverfahren mit den Merkmalen des Oberbegriffs des Anspruchs 6 ist aus der US-A-5 394 358 bekannt.

Dieses Problem wird gelöst durch eine SRAM-Zellenanordnung gemäß Anspruch 1 sowie ein Verfahren zu deren Herstellung gemäß Anspruch 6. Weitere Ausgestaltungen der Erfindung gehen aus den übrigen Ansprüchen hervor.

In einer erfindungsgemäßen Schaltungsanordnung umfaßt eine Speicherzelle mindestens einen ersten Transistor, einen zweiten Transistor, einen dritten Transistor, einen vierten Transistor, einen fünften Transistor und einen sechsten Transistor. Der erste Transistor, der zweite Transistor, der dritte Transistor und der vierte Transistor bilden eine Flip-Flop-Schaltung, die über den fünften Transistor und über den sechsten Transistor angesteuert wird und die zwischen einen ersten Spannungsanschluß und einen zweiten Spannungsanschluß geschaltet ist. Der dritte Transistor und der vierte Transistor sind zum ersten Transistor und zum zweiten Transistor komplementär. Der fünfte Transistor und der sechste Transistor werden über eine Wortleitung angesteuert. Ein zweites Source/Drain-Gebiet des fünften Transistors ist mit einer ersten Bitleitung und ein zweites Source/Drain-Gebiet des sechsten Transistors ist mit einer zweiten Bitleitung verbunden. Die erste Bitleitung und die zweite Bitleitung verlaufen quer zur Wortleitung. Der erste Transistor, der zweite Transistor, der dritte Transistor und der vierte Transistor sind an Ecken eines Vierecks angeordnet, so daß die Ecke, an der der erste Transistor angeordnet ist, und die Ecke, an der der vierte Transistor angeordnet ist, sich diagonal gegenüberliegen. Der dritte Transistor ist zwischen dem ersten Transistor und dem fünften Transistor angeordnet. Der zweite Transistor ist zwischen dem vierten Transistor und dem sechsten Transistor angeordnet.

Diese Anordnung bietet den Vorteil, daß die Wortleitung, die erste Bitleitung, die zweite Bitleitung, die Verbindung zum ersten Spannungsanschluß und die Verbindung zum zweiten Spannungsanschluß als im wesentlichen gerade streifenförmige Strukturen ausgebildet sein können. Da streifenförmige Strukturen nah beieinander angeordnet werden können, ist die SRAM-Zellenanordnung mit erhöhter Packungsdichte herstellbar.

Darüber hinaus können die erste Bitleitung und die zweite Bitleitung nebeneinander angeordnet sein, so daß sie als Teile des Substrats ausgebildet werden können. Sind die Bitleitungen oberhalb des Substrats angeordnet, so können beide Bitleitungen, wenn sie nebeneinander angeordnet sind, aus einer einzigen Metallisierungsebene erzeugt werden, was eine Prozeßvereinfachung bedeutet.

Die Verbindungslinie zwischen dem ersten Transistor, dem dritten Transistor und dem fünften Transistor verläuft parallel zur Wortleitung. Die Verbindungslinie zwischen dem sechsten Transistor, dem zweiten Transistor und dem vierten Transistor verläuft parallel zur Wortleitung. Die Verbindungslinie zwischen dem ersten Transistor und dem zweiten Transistor verläuft parallel zu einer z-Achse, die die Wortleitung kreuzt. Die Verbindungslinie zwischen dem dritten Transistor und dem vierten Transistor verläuft parallel zur z-Achse. Die Verbindungslinie zwischen dem fünften Transistor und dem sechsten Transistor kreuzt die z-Achse und verläuft quer zur Richtung der Wortleitung.

Es liegt im Rahmen der Erfindung zur Verbesserung verschiedener Eigenschaften der SRAM-Zellenanordnung zusätzlich zu den sechs Transistoren der Speicherzelle weitere Bauelemente, wie z.B. Kondensatoren, Widerstände, Dioden oder weitere Transistoren, in die Speicherzelle zu integrieren.

Der erste Transistor, der dritte Transistor und der fünfte Transistor können in Wortleitungsrichtung nebeneinander angeordnet sein. Der zweite Transistor, der vierte Transistor und der sechste Transistor können ebenfalls in Wortleitungsrichtung nebeneinander angeordnet sein. Eine Verbindungslinie zwischen der Ecke, an der der erste Transistor angeordnet ist, und der Ecke, an der der zweite Transistor angeordnet ist, kann parallel zur z-Achse verlaufen. Eine Verbindungslinie zwischen der Ecke, an der der dritte Transistor angeordnet ist, und der Ecke, an der der vierte Transistor angeordnet ist, kann parallel zur z-Achse, verlaufen. Bei dieser Anordnung ist es zur Erhöhung der Packungsdichte vorteilhaft, wenn die erste Bitleitung, die zweite Bitleitung, die Verbindung zum ersten Spannungsanschluß und die Verbindung zum zweiten Spannungsanschluß streifenförmig sind und im wesentlichen parallel zur z-Achse verlaufen. Die Verbindung zum ersten Spannungsanschluß kann die Ecke, an der der erste Transistor angeordnet ist, und die Ecke, an der der zweite Transistor angeordnet ist, überlappen. Die Verbindung zum zweien Spannungsanschluß kann die Ecke, an der der dritte Transistor angeordnet ist, und die Ecke, an der der vierte Transistor angeordnet ist, überlappen.

Das Viereck kann eine Rechteck sein, dessen Seiten vier im wesentlichen rechte Winkel bilden.

Eine erste Speicherzelle und eine zweite Speicherzelle, die entlang der Wortleitung zueinander benachbart sind, können translationssymmetrisch oder um 180° rotationssymmetrisch zueinander aufgebaut sein. Dadurch läßt sich die Packungsdichte erhöhen, da die Speicherzellen ohne Flächenverlust aneinandergereiht werden können. Eine Verbindungslinie zwischen einem der Transistoren der ersten Speicherzelle und einem der Transistoren der zweiten Speicherzelle verläuft parallel zur z-Achse. Dabei kann der besagte Transistor der ersten Speicherzelle der fünfte oder der sechste Transistor sein. Dasselbe gilt für den besagten Transistor der zweiten Speicherzelle. Vorzugsweise ist der besagte Transistor der ersten Speicherzelle der fünfte Transistor der ersten Speicherzelle, wenn der besagte Transistor der zweiten Speicherzelle der sechste Transistor der zweiten Speicherzelle ist, oder der sechste Transistor der ersten Speicherzelle, wenn der besagte Transistor der zweiten Speicherzelle der fünfte Transistor der zweiten Speicherzelle ist. Zur Erhöhung der Packungsdichte dient eine erste Bitleitung der ersten Speicherzelle als zweite Bitleitung der zweiten Speicherzelle.

Zur Erhöhung der Packungsdichte ist es vorteilhaft, wenn ein erster Kontakt zur Wortleitung sowohl eine Gateelektrode des sechsten Transistors (im folgenden auch als "sechste Gateelektrode" bezeichnet) als auch eine Gateelektrode des fünften Transistors (im folgenden auch als "fünfte Gateelektrode" bezeichnet) von zwei entlang der Wortleitung benachbarten Speicherzellen kontaktiert. Dadurch ergeben sich pro Speicherzelle nur zwei halbe Kontakte zur Wortleitung.

Es liegt im Rahmen der Erfindung, die erste Bitleitung, die zweite Bitleitung, die Verbindung zum ersten Spannungsanschluß und/oder die Verbindung zum zweiten Spannungsanschluß als dotierte Gebiete in einem Substrat auszubilden. Alternativ können sie als leitende Strukturen oberhalb des Substrats oder/und angrenzend an das Substrat ausgebildet sein.

Zur Erhöhung der Packungsdichte ist es vorteilhaft, wenn der erste Transistor, der zweite Transistor, der dritte Transistor, der vierte Transistor, der fünfte Transistor und/oder der sechste Transistor vertikale MOS-Transistoren sind.

Es liegt im Rahmen der Erfindung, die Transistoren an Flanken von mindestens einer Halbleiterstruktur anzuordnen. Der Querschnitt der Halbleiterstruktur kann beliebig sein. Insbesondere kann die Halbleiterstruktur ringförmig sein, was eine große Kanalweite bei gleichzeitig besonders hoher Packungsdichte bewirkt. Zur Prozeßvereinfachung ist es vorteilhaft, wenn die Halbleiterstruktur stegförmig ist.

Untere Source/Drain-Gebiete der Transistoren können innerhalb der Halbleiterstruktur angeordnet sein. Zur Vermeidung von Punch-Through oder von Kapazitäten, die jeweils durch ein oberes und ein unteres Source/Drain-Gebiet gebildet werden, ist es vorteilhaft, wenn die unteren Source/Drain-Gebiete lateral zu den Halbleiterstrukturen angrenzend an Flanken der Halbleiterstrukturen angeordnet sind. In diesem Fall können obere Source/Drain-Gebiete und untere Source/Drain-Gebiete eines Transistors gleichzeitig und selbstjustiert zueinander und zur Halbleiterstruktur, d.h. ohne Verwendung von zu justierenden Masken, durch Implantation erzeugt werden. Dies verringert zum einen den Prozeßaufwand und erlaubt zum anderen besonders kleine Strukturgrößen, da Justiertoleranzen nicht berücksichtigt werden müssen.

Es liegt im Rahmen der Erfindung mehrere Transistoren an einer Halbleiterstruktur anzuordnen. Dadurch können Verbindungen zwischen Source/Drain-Gebieten der Transistoren innerhalb der Halbleiterstruktur verlaufen, was sowohl den Prozeßaufwand verkleinert als auch die Packungsdichte erhöht. Um Source/Drain-Gebiete voneinander zu trennen, können Vertiefungen in die Halbleiterstruktur erzeugt werden.

Für ein symmetrisches Schaltverhalten von p-Kanal-Transistoren und n-Kanal-Transistoren ist es vorteilhaft, wenn die Kanalweite von p-Kanal-Transistoren etwa doppelt so groß ist wie die Kanalweite von n-Kanal-Transistoren. Beispielsweise können die Kanalweiten des dritten Transistors und des vierten Transistors doppelt so groß sein, wie die Kanalweiten des ersten Transistors und des zweiten Transistors. Zur Prozeßvereinfachung können gleichgroße Halbleiterstrukturen erzeugt werden, p-Kanal-Transistoren jeweils an Flanken von zwei Halbleiterstrukturen angeordnet werden und n-Kanal-Transistoren jeweils an Flanken einer Halbleiterstruktur angeordnet werden.

Zur Erhöhung der Packungsdichte ist es vorteilhaft, wenn der fünfte und der sechste Transistor n-Kanal-Transistoren sind.

Zur Erzeugung der Halbleiterstrukturen kann eine Schichtenfolge erzeugt werden. Die Schichtenfolge umfaßt mindestens eine von einem ersten Leitfähigkeitstyp dotierte erste Schicht, eine darüberliegende von einem zweiten, zum ersten Leitfähigkeitstyp entgegengesetzten Leitfähigkeitstyp dotierte zweite Schicht, eine darüberliegende vom ersten Leitfähigkeitstyp dotierte dritte Schicht und eine darüberliegende vom zweiten Leitfähigkeitstyp dotierte vierte Schicht. Es liegt im Rahmen der Erfindung zwischen diesen Schichten Hilfsschichten anzuordnen. Durch mehrstufiges maskiertes Ätzen der Schichtenfolge werden die Halbleiterstrukturen erzeugt. Damit sowohl NMOS- als auch PMOS-Transistoren aus einer Schichtenfolge erzeugt werden können, werden zueinander komplementäre Transistoren in unterschiedlicher Höhe angeordnet. In den Halbleiterstrukturen befindliche Teile der zweiten Schicht und der dritten Schicht sind beispielsweise als Kanalgebiete geeignet. Es liegt im Rahmen der Erfindung weitere dotierte Schichten als Teil der Schichtenfolge zu erzeugen und auch nicht zueinander komplementäre Transistoren in unterschiedlicher Höhe anzuordnen. Auch können dann Kanalgebiete zueinander komplementärer Transistoren in nicht aneinanderangrenzenden Schichten der Schichtenfolge ausgebildet sein.

Die erste Schicht kann n-dotiert oder p-dotiert sein.

Die Schichtenfolge kann z.B. durch Epitaxie und/oder durch Implantation erzeugt werden. Statt einer homogen dotierten Schicht kann auch eine Schicht mit dotierten Gebieten verwendet werden. Dies stellt eine Vorstrukturierung dar, die den Prozeßaufwand bezüglich der Strukturierung der Schichtenfolge sowie der Erzeugung leitender Strukturen, wie z.B. Bitleitungen, verringert.

Leckströme aufgrund parasitärer Bipolartransistoren können unterdrückt werden, wenn ein Kanalstrom sich im ganzen Kanalgebiet entwickeln kann. Deshalb ist es vorteilhaft, wenn ein senkrecht zum Kanalstrom verlaufender Querschnitt durch die Halbleiterstrukturen besonders klein ist. Dazu können die Halbleiterstrukturen mit Hilfe einer Maske mit Abmessungen, die kleiner als die minimale in der verwendeten Technologie herstellbare Strukturgröße F sind, erzeugt werden. Die Maske kann z.B. durch Unterätzen einer strukturierten Schicht erzeugt werden. Alternativ kann die Maske z.B. spacerförmig sein. Die spacerförmige Maske wird beispielsweise an einer Kante einer strukturierten Hilfsschicht erzeugt, indem Material abgeschieden und rückgeätzt wird. Die dabei entstehenden Spacer können anschließend noch strukturiert werden.

Es liegt im Rahmen der Erfindung, wenn jeder Transistor an mindestens einer Halbleiterstruktur ausgebildet wird. Zur Erzeugung der Halbleiterstrukturen wird beispielsweise auf die Schichtenfolge eine erste Hilfsschicht abgeschieden. In die erste Hilfsschicht werden parallel zur z-Achse verlaufende Gräben erzeugt. Durch Abscheiden und Rückätzen von Material werden an Flanken der Gräben Spacer erzeugt. Die Spacer werden mit Hilfe einer Maske, die streifenförmige, quer zu den Gräben verlaufende Bereiche bedeckt, strukturiert, wodurch aus den Spacern eine erste Maske entsteht. Mit Hilfe der ersten Maske wird die Schichtenfolge geätzt, bis die zweite Schicht teilweise freigelegt wird.

Dabei entstehen Halbleiterstrukturen von Transistoren mit vom ersten Leitfähigkeitstyp dotierten Kanalgebieten sowie vorläufige Halbleiterstrukturen. Aus den vorläufigen Halbleiterstrukturen werden Halbleiterstrukturen der Transistoren mit vom zweiten Leitfähigkeitstyp dotierten Kanalgebieten erzeugt, indem mit Hilfe einer zweiten Maske, die mindestens die Halbleiterstrukturen der Transistoren mit vom ersten Leitfähigkeitstyp dotierten Kanalgebieten sowie umgebende Bereiche bedeckt, die Schichtenfolge geätzt wird, bis die erste Schicht teilweise freigelegt wird. Es ist vorteilhaft, wenn die zweite Maske streifenförmig ist und deren Streifen parallel zur z-Achse verlaufen. Dadurch können aus Teilen der ersten Schicht und der zweiten Schicht leitende Strukturen, wie z.B. Bitleitungen, erzeugt werden.

Zur Isolierung benachbarter Transistoren voneinander ist es vorteilhaft, wenn mit Hilfe einer Maske, die mindestens die Halbleiterstrukturen der Transistoren mit vom ersten Leitfähigkeitstyp dotierten Kanalgebieten und umgebende Bereiche bedeckt, die Schichtenfolge geätzt wird, bis die dritte Schicht und das Substrat teilweise freigelegt werden. Ein weiterer Vorteil ist, daß dabei überflüssige Teile der vierten Schicht in den Halbleiterstrukturen der Transistoren mit vom zweiten Leitfähigkeitstyp dotierten Kanalgebieten entfernt werden.

Es liegt im Rahmen der Erfindung mit Hilfe einer streifenförmigen vierten Maske, deren Streifen parallel zur z-Achse verlaufen und die Transistoren mit vom ersten Leitfähigkeitstyp dotierten Kanalgebieten und sie umgebende Bereiche bedeckt, eine Implantation durchzuführen. Dadurch wird die Dotierstoffkonzentration der Source/Drain-Gebiete der Transistoren mit vom zweiten Leitfähigkeitstyp dotierten Kanalgebieten selbstjustiert, d.h. ohne Verwendung zusätzlicher zu justierenden Masken, in oberen Teilen der Halbleiterstrukturen sowie lateral an die Halbleiterstrukturen angrenzend erhöht. Auch werden dabei in der ersten Schicht verlaufende streifenförmige dotierte Gebiete erzeugt. Mit Hilfe einer zur vierten Maske komplementären fünften Maske wird durch Implantation die Dotierstoffkonzentration der Source/Drain-Gebiete der Transistoren mit vom ersten Leitfähigkeitstyp dotierten Kanalgebieten erhöht. Dabei entstehen in der ersten Schicht streifenförmige dotierte Gebiete. Ein erstes dotiertes Gebiet der streifenförmigen dotierten Gebiete, das ein erstes Source/Drain-Gebiet des ersten Transistors und ein erstes Source/Drain-Gebiet des zweiten Transistors umfaßt, ist mit dem ersten Spannungsanschluß verbunden. Das erste dotierte Gebiet kann in der ersten Schicht oder in der zweiten Schicht ausgebildet sein. Ein zweites dotiertes Gebiet der streifenförmigen dotierten Gebiete, das ein zweites Source/Drain-Gebiet des dritten Transistors und ein zweites Source/Drain-Gebiet des vierten Transistors umfaßt, ist mit einem zweiten Spannungsanschluß verbunden. Andere der streifenförmigen dotierten Gebiete, die ein zweites Source/Drain-Gebiet des sechsten Transistors bzw. ein zweites Source/Drain-Gebiet des fünften Transistors umfassen, sind als zweite Bitleitung bzw. als erste Bitleitung geeignet.

Zur Verkleinerung der Kapazität, die durch eine Gateelektrode und ein darunterliegendes Source/Drain-Gebiet gebildet wird, ist es vorteilhaft, auf dem Source/Drain-Gebiet eine Abstandsschicht zu erzeugen. Dazu wird z.B. anisotrop isolierendes Material aufgebracht und isotrop wieder entfernt, so daß an Flanken der Halbleiterstrukturen das Material vollständig entfernt wird und an horizontalen Flächen eine Abstandsschicht erzeugt wird.

Es liegt im Rahmen der Erfindung, nach Erzeugung eines Gatedielektrikums leitendes Material abzuscheiden und mit Hilfe einer sechsten Maske zu ätzen, die Bereiche zwischen den Transistoren derart bedeckt, daß Gateelektroden, die die Halbleiterstrukturen umgeben, eine erste leitende Struktur, die die sechste Gateelektrode und die fünfte Gateelektrode entlang der Wortleitung benachbarter Speicherzellen überlappt, zwischen dem ersten Transistor und dem zweiten Transistor eine zweite leitende Struktur, die eine zweite Gateelektrode des zweiten Transistors ("zweite Gateelektrode") überlappt, zwischen dem zweiten Transistor und dem vierten Transistor eine dritte leitende Struktur, die die zweite Gateelektrode und eine Gateelektrode des vierten Transistors ("vierte Gateelektrode") überlappt, zwischen dem dritten und dem vierten Transistor eine vierte leitende Struktur, die eine Gateelektrode des dritten Transistors ("dritte Gateelektrode") überlappt, und zwischen dem ersten Transistor und dem dritten Transistor eine fünfte leitende Struktur, die die erste Gateelektrode und die dritte Gateelektrode überlappt, entstehen.

Zur Einstellung der Einsatzspannung ist es möglich, die Kanalgebiete durch schräge Implantation zu dotieren.

Zur Verringerung eines Widerstands zwischen Source/Drain-Gebieten und Kontakten, bzw. leitenden Strukturen, ist es vorteilhaft durch Silizierung auf den betreffenden Source/Drain-Gebieten eine Silizidschicht zu bilden.

Die Schichtenfolge kann eine Siliziumschicht und/oder eine Si₍₁₋ₓ₎Geₓ-Schicht enthalten.

Das Substrat kann z.B. eine Halbleiterscheibe oder ein SOI-Substrat, d.h. ein Substrat, das eine dünne monokristalline Siliziumschicht auf einer SiO₂-Schicht umfaßt, sein.

Im folgenden wird ein Ausführungsbeispiel der Erfindung, daß in den Figuren dargestellt ist, näher erläutert.
- Figur 1: zeigt einen Querschnitt durch ein Substrat, nachdem eine erste Schicht, eine zweite Schicht, eine dritte Schicht und eine vierte Schicht epitaktisch aufgewachsen, eine erste Hilfsschicht abgeschieden und strukturiert und Spacer erzeugt wurden.
- Figur 2: zeigt den Querschnitt aus Figur 1, nachdem eine erste Maske, eine zweite Maske und Halbleiterstrukturen erzeugt wurden.
- Figur 3: zeigt den Querschnitt aus Figur 2, nachdem die erste Maske und die zweite Maske entfernt wurden, eine erste Hilfsstruktur erzeugt wurde und Teile der ersten Schicht und der vierten Schicht entfernt wurden.
- Figur 4: zeigt den Querschnitt aus Figur 3, nachdem die erste Hilfsstruktur teilweise entfernt wurde, Source/Drain-Gebiete des dritten Transistors (nicht dargestellt) und des vierten Transistors und ein zweites dotiertes Gebiet erzeugt wurden.
- Figur 5: zeigt den Querschnitt aus Figur 4, nachdem eine zweite Hilfsstruktur, Source/Drain-Gebiete des ersten Transistors (nicht dargestellt) des zweiten Transistors, des fünften Transistors (nicht dargestellt) des sechsten Transistors, ein erstes dotiertes Gebiet, eine erste Bitleitung und eine zweite Bitleitung erzeugt wurden.
- Figur 6: zeigt den Querschnitt aus Figur 5, nachdem eine Abstandsschicht und ein Gatedielektrikum erzeugt wurden.
- Figur 7: zeigt den Querschnitt aus Figur 6, nachdem Gateelektroden, leitende Strukturen und eine erste isolierende Struktur, erzeugt wurden.
- Figur 8: zeigt den Querschnitt aus Figur 7, nachdem eine zweite isolierende Struktur erzeugt wurde.

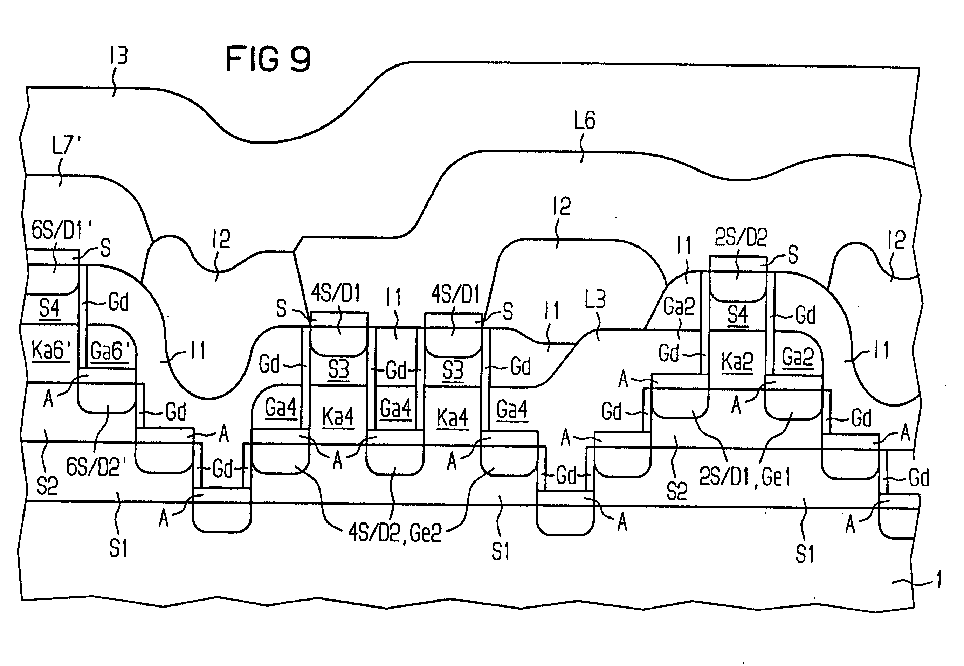

- Figur 9: zeigt den Querschnitt aus Figur 8, nachdem leitende Strukturen, eine dritte isolierende Struktur, Silizidschichten, Kontakte (nicht dargestellt), und Wortleitungen (nicht dargestellt) erzeugt wurden.
- Figur 10: zeigt eine Aufsicht auf das Substrat, nachdem eine Hilfsschicht, Gräben und Spacer erzeugt wurden.
- Figur 11: zeigt die Aufsicht aus Figur 10, in der Halbleiterstrukturen, Gateelektroden, mit den Gateelektroden überlappende leitende Strukturen und eine Wortleitung dargestellt sind.
- Figur 12: zeigt die Aufsicht aus Figur 11, in der die Halbleiterstrukturen und leitende Strukturen dargestellt sind.

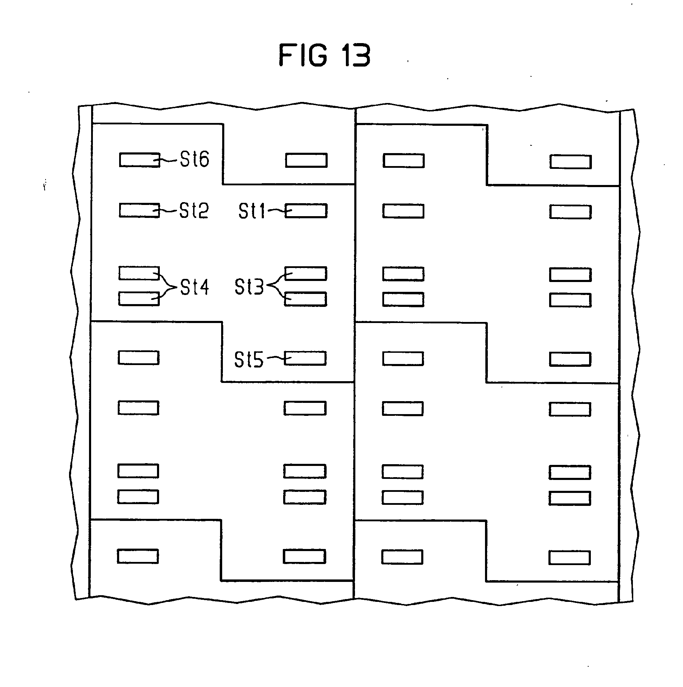

- Figur 13: zeigt die Aufsicht aus Figur 12, in der die Anordnung der Speicherzellen veranschaulicht ist.

Die Figuren sind nicht maßstabsgetreu.

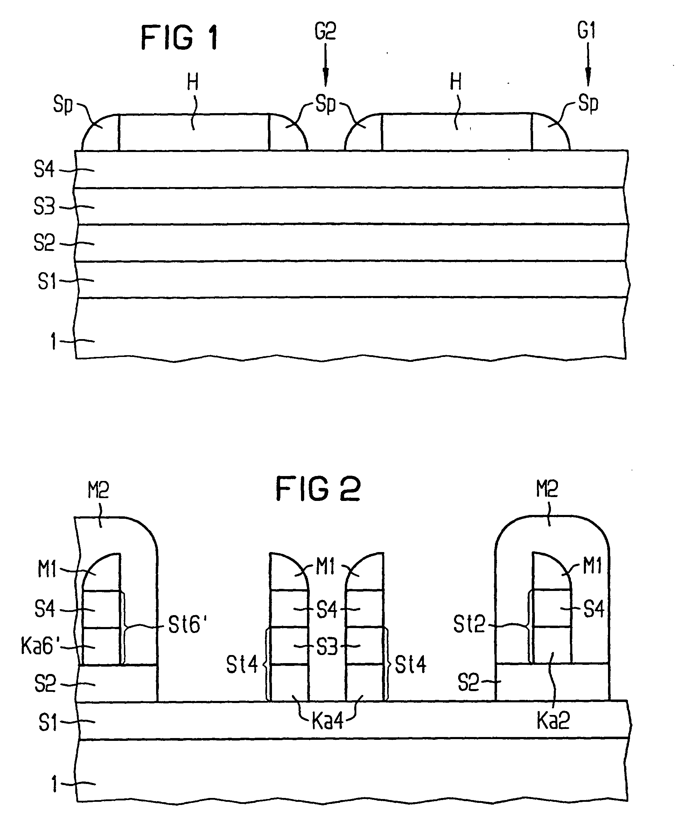

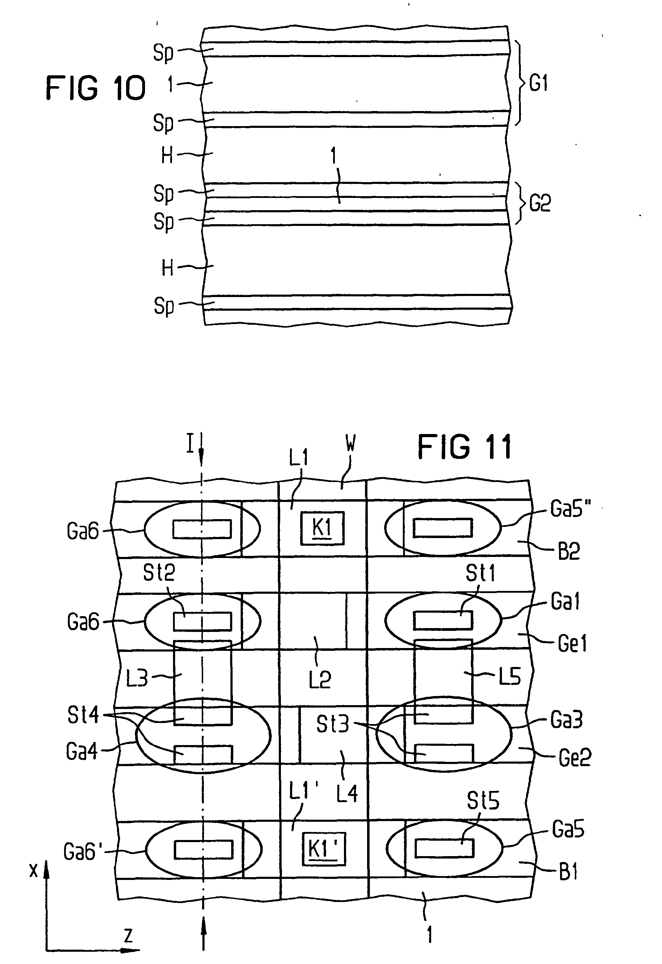

Ausgangsmaterial ist ein n-dotiertes Substrat 1 aus Silizium mit einer Dotierstoffkonzentration von ca. 10¹⁷ ***cm***⁻³. Auf dem Substrat 1 wird eine Schichtenfolge erzeugt, indem durch Epitaxie mit insitu-Dotierung eine ca. 100nm dicke p-dotierte erste Schicht 51, eine ca. 100nm dicke n-dotierte zweite Schicht S2, eine ca. 100nm dicke p-dotierte dritte Schicht 53 und eine ca. 100nm dicke n-dotierte vierte Schicht S4 aufgewachsen werden. Die Dotierstoffkonzentrationen der ersten Schicht S1, der zweiten Schicht S2, der dritten Schicht S3 und der vierten Schicht S4 betragen ca. 10¹⁸ ***cm***⁻³. Auf die Schichtenfolge wird eine ca. 200nm dicke Hilfsschicht H aus SiO₂ abgeschieden. Durch ein photolithographisches Verfahren wird die Hilfsschicht H strukturiert, indem parallel zueinander verlaufende erste Gräben G1 und zweite Gräben G2 erzeugt werden. Die ersten Gräben G1 und die zweiten Gräben G2 verlaufen parallel zu einer z-Achse z (siehe Figur 1 und Figur 10). Der erste Graben G1 ist ca 700nm und der zweite Graben G2 ca. 300nm breit. Ein Abstand zwischen den Mittellinien benachbarter Gräben beträgt ca. 900nm.

Zur Erzeugung von Spacern Sp wird Siliziumnitrid abgeschieden und rückgeätzt. Aus den Spacern Sp entsteht eine erste Maske M1, indem Siliziumnitrid in parallel zu einer x-Achse x, die senkrecht zur z-Achse z verläuft, verlaufende Streifen geätzt wird. Die Streifen sind ca. 900nm breit und ein Abstand zwischen den Mittellinien benachbarter Streifen beträgt ca. 1200nm (siehe Figur 2 und Figur 10).

Mit Hilfe der ersten Maske M1 wird Silizium geätzt. Dabei wird die vierte Schicht S4 und die dritte Schicht S3 durchtrennt und die zweite Schicht S2 freigelegt (siehe Figur 2). Dabei entstehen Halbleiterstrukturen St1, St2, St5, St6 des ersten Transistors, des zweiten Transistors, des fünften Transistors und des sechsten Transistors sowie vorläufige Halbleiterstrukturen des dritten Transistors und des vierten Transistors. Zur Erzeugung einer streifenförmigen zweiten Maske M2, deren Streifen ca. 300nm breit sind, parallel zur z-Achse z verlaufen und den ersten Transistor, den zweiten Transistor, den fünften Transistor und den sechsten Transistor sowie sie umgebende Bereiche bedecken, wird SiO₂ abgeschieden und durch ein photolithographisches Verfahren strukturiert (siehe Figur 2). Mit Hilfe der zweiten Maske M2 und der ersten Maske M1 wird Silizium geätzt, bis die erste Schicht S1 teilweise freigelegt wird (siehe Figur 2). Dadurch entstehen aus den vorläufigen Halbleiterstrukturen des dritten Transistors und des vierten Transistors die Halbleiterstrukturen St3, St4 des dritten Transistors und des vierten Transistors. Die Maske M2 schützt Teile der zweiten Schicht S2 zwischen dem ersten Transistor und dem zweiten Transistor einer Speicherzelle und zwischen dem sechsten Transistor und dem fünften Transistor entlang der x-Achse x benachbarter Speicherzellen.

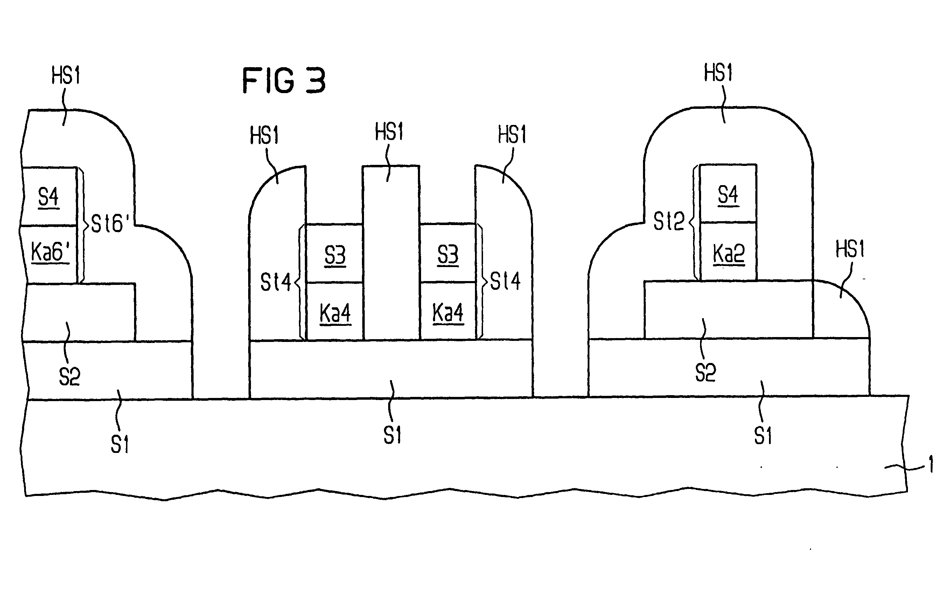

Anschließend wird die erste Maske M1 und die zweite Maske M2 mit z.B. NH₄F/HF und anschließend H₃PO₄ bei 150°C entfernt. Dann wird eine erste Hilfsstruktur HS1 erzeugt, indem SiO₂ in einer Dicke von ca. 100nm abgeschieden und mit einer streifenförmigen dritten Maske (nicht dargestellt), deren Streifen etwas breiter als die zweite Maske M2 sind, geätzt wird, bis die vierte Schicht S4 in den Halbleiterstrukturen St3, St4 des dritten Transistors und des vierten Transistors freigelegt wird (siehe Figur 3). Durch Ätzen von Silizium selektiv zu SiO₂ mit z.B. Cl₂/CHF₃ wird die vierte Schicht S4 und die erste Schicht S1 teilweise entfernt, bis die dritte Schicht S3 und das Substrat 1 teilweise freigelegt werden. Dadurch werden entlang der x-Achse x benachbarte Transistoren voneinander getrennt.

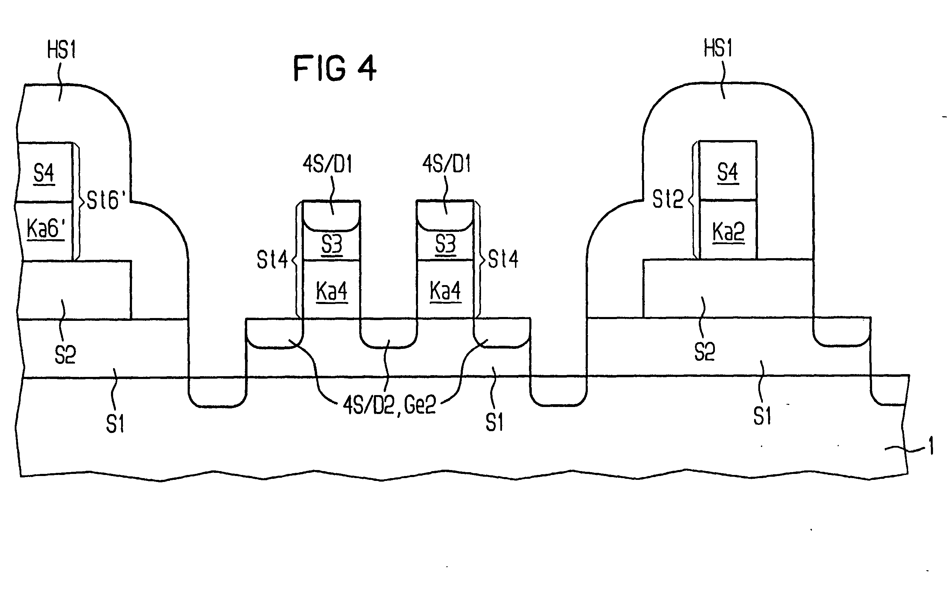

Unter Verwendung einer zur dritten Maske analogen streifenförmigen vierten Maske (nicht dargestellt) wird SiO₂ selektiv zu Silizium mit z.B. CHF₃/CF₄ geätzt, bis Teile der ersten Hilfsstruktur HS1, die an Flanken der Halbleiterstrukturen St3, St4 des dritten Transistors und des vierten Transistors angrenzen, entfernt werden (siehe Figur 4).

Unter Verwendung der ersten Hilfsstruktur HS1 als Maske werden durch Implantation in Teilen der dritten Schicht S3 der Halbleiterstrukturen St3 des dritten Transistors ein erstes Source/Drain-Gebiet des dritten Transistors und in Teilen der dritten Schicht S3 in den Halbleiterstrukturen St4 des vierten Transistors erste Source/Drain-Gebiete 4 S/D1 des vierten Transistors, in Teilen der ersten Schicht S1 ein zweites dotiertes Gebiet Ge2 als Teil des zweiten dotierten Gebiets Ge2 an Flanken der Halbleiterstrukturen St3 des dritten Transistors angrenzend zweite Source/Drain-Gebiete des dritten Transistors und als Teile des zweiten dotierten Gebiets Ge2 an Flanken der Halbleiterstrukturen St4 des vierten Transistors angrenzend zweite Source/Drain-Gebiete 4 S/D2 des vierten Transistors (siehe Figur 4). Diese Source/Drain-Gebiete entstehen also selbstjustiert zueinander, d.h. ohne Verwendung von zusätzlichen zu justierenden Masken. Anschließend wird durch Ätzen von SiO₂ selektiv zu Silizium, mit z.B. NH₄F/HF, die erste Hilfsstruktur HS1 entfernt.

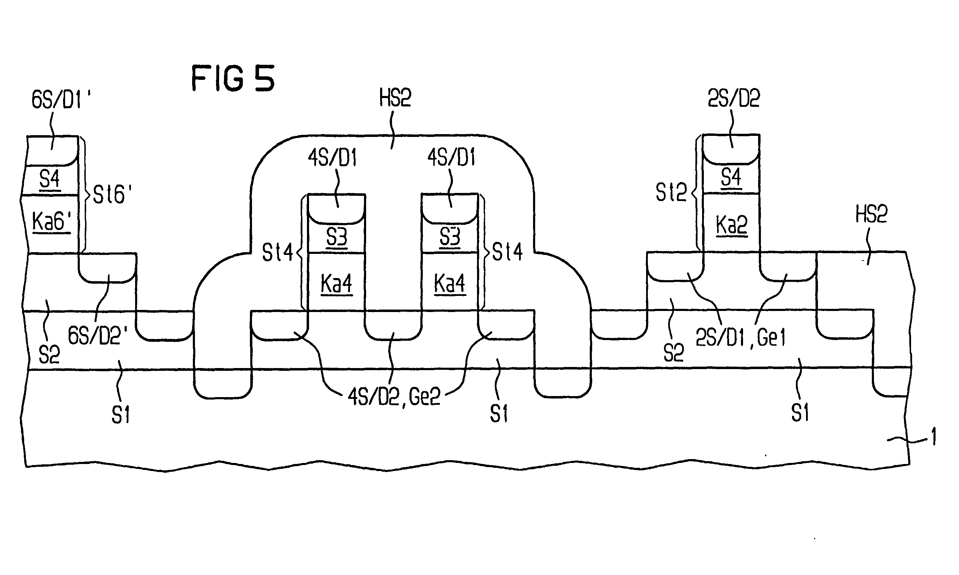

Zur Erzeugung einer zweiten Hilfsstruktur HS2, wird SiO₂ in einer Dicke von ca. 100nm abgeschieden und mit Hilfe einer zur vierten Maske komplementären fünften Maske strukturiert. Die zweite Hilfsstruktur HS2 ist streifenförmig und bedeckt die Halbleiterstrukturen St3, St4 des dritten Transistors und des vierten Transistors, sowie umliegende Bereiche. Unter Verwendung der zweiten Hilfsstruktur HS2 als Maske werden durch Implantation in einem Teil der vierten Schicht S4, der sich in der Halbleiterstruktur St1 des ersten Transistors befindet, ein n-dotiertes zweites Source/Drain-Gebiet des ersten Transistors, in einem Teil der vierten Schicht S4, der sich in der Halbleiterstruktur St2 des zweiten Transistors befindet, ein zweites Source/Drain-Gebiet 2 S/D2 des zweiten Transistors, in einem Teil der vierten Schicht S4, der sich in der Halbleiterstruktur St5 des fünften Transistors befindet, ein erstes Source/Drain-Gebiet des fünften Transistors, in einem Teil der vierten Schicht S4, der sich in der Halbleiterstruktur St6 des sechsten Transistors befindet, ein erstes Source/Drain-Gebiet des sechsten Transistors, in einem streifenförmigen Teil der zweiten Schicht S2, der mit der Halbleiterstruktur St2 des zweiten Transistors und der Halbleiterstruktur St1 des ersten Transistors überlappt, ein erstes dotiertes Gebiet Ge1, in streifenförmigen Teilen der zweiten Schicht S2, die mit den Halbleiterstrukturen St5, St6 des fünften Transistors und des sechsten Transistors entlang der x-Achse x benachbarter Speicherzellen überlappen, eine erste Bitleitung B1 und eine zweite Bitleitung B2 erzeugt (siehe Figur 5 und Figur 11).

Die erste Bitleitung B1 dient für eine der Speicherzelle entlang der x-Achse x erste benachbarte Speicherzelle als zweite Bitleitung. Damit ist ein zweites Source/Drain/Gebiet 6S/D2' eines sechsten Transistors der ersten benachbarten Speicherzelle Teil der ersten Bitleitung B1. Die zweite Bitleitung B2 dient für eine der Speicherzelle entlang der x-Achse x zweite benachbarte Speicherzelle als erste Bitleitung. Damit ist ein zweites Source/Drain/Gebiet eines fünften Transistors der zweiten benachbarten Speicherzelle Teil der zweiten Bitleitung B2. Anschließend wird die zweite Hilfsstruktur HS2 durch Ätzen mit z.B. NH₄F/HF entfernt.

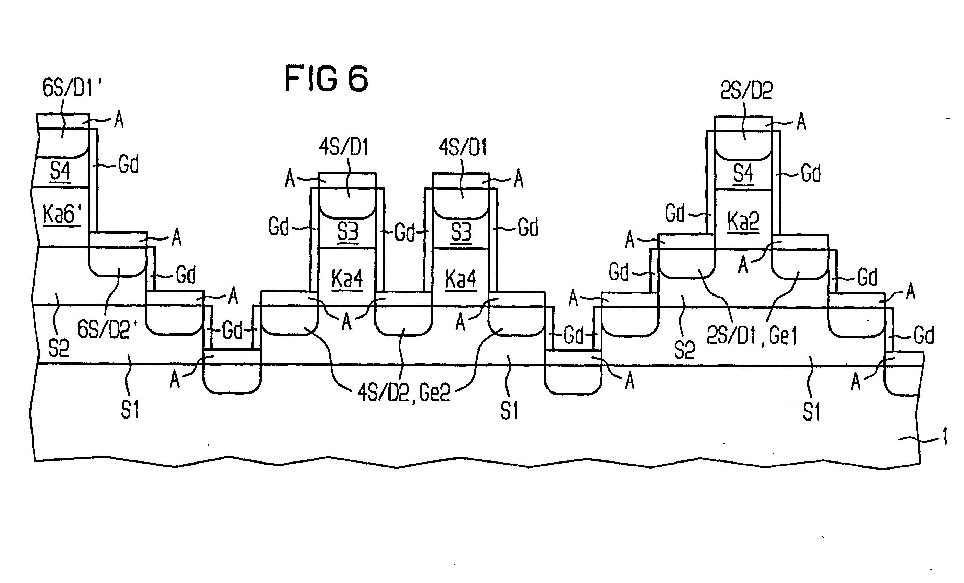

Durch anisotropes Aufbringen von SiO₂ und isotropes Entfernen mit z.B. NH₄F/HF, bis SiO₂ von Flanken der Halbleiterstrukturen St1, St2, St3, St4, St5, St6 entfernt wird, entsteht an horizontalen Flächen ca. 20nm dicke Abstandsschichten A (siehe Figur 6).

Nach einem Reinigungsschritt wird durch thermische Oxidation ein ca. 5nm dickes Gatedielektrikum Gd erzeugt (siehe Figur 6).

Zur Erzeugung von Gateelektroden und leitenden Strukturen wird insitu dotiertes Polysilizium abgeschieden und mit Hilfe einer sechsten Maske (nicht dargestellt) geätzt, bis spacerförmige Gateelektroden in Höhe der Kanalgebiete die Halbleiterstrukturen St1, St2, St3, St4, St5, St6 der Transistoren umgeben. Die sechste Maske bedeckt einen Teil zwischen dem fünften Transistor und dem sechsten Transistor entlang der z-Achse z benachbarter Speicherzellen derart, daß eine erste leitende Struktur z.B. L1 oder L1' entsteht, die eine fünfte Gateelektrode z.B. Ga5 oder Ga5'' und eine sechste Gateelektrode z.B. Ga6 oder Ga6' dieser Transistoren überlappt. Die sechste Maske bedeckt einen Bereich zwischen dem zweiten Transistor und dem ersten Transistor derart, daß eine zweite leitende Struktur L2 entsteht, die die zweite Gateelektrode Ga2 des zweiten Transistors überlappt. Die sechste Maske bedeckt einen Bereich zwischen dem zweiten Transistor und dem vierten Transistor derart, daß eine dritte leitende Struktur L3 entsteht, die eine zweite Gateelektrode Ga2 des zweiten Transistors und die vierte Gateelektrode Ga4 des vierten Transistors überlappt. Die sechste Maske bedeckt einen Bereich zwischen dem vierten Transistor und dem dritten Transistor derart, daß eine vierte leitende Struktur L4 entsteht, die eine dritte Gateelektrode Ga3 des dritten Transistors überlappt. Die sechste Maske bedeckt einen Bereich zwischen dem ersten Transistor und dem dritten Transistor derart, daß eine fünfte leitende Struktur L5 entsteht, die die erste Gateelektrode Ga1 und die dritte Gateelektrode Ga3 überlappt (siehe Figur 11). Die Abstandsschichten A verkleinert Kapazitäten, die jeweils durch eine Gateelektrode und ein darunter liegendes Source/Drain-Gebiet gebildet wird.

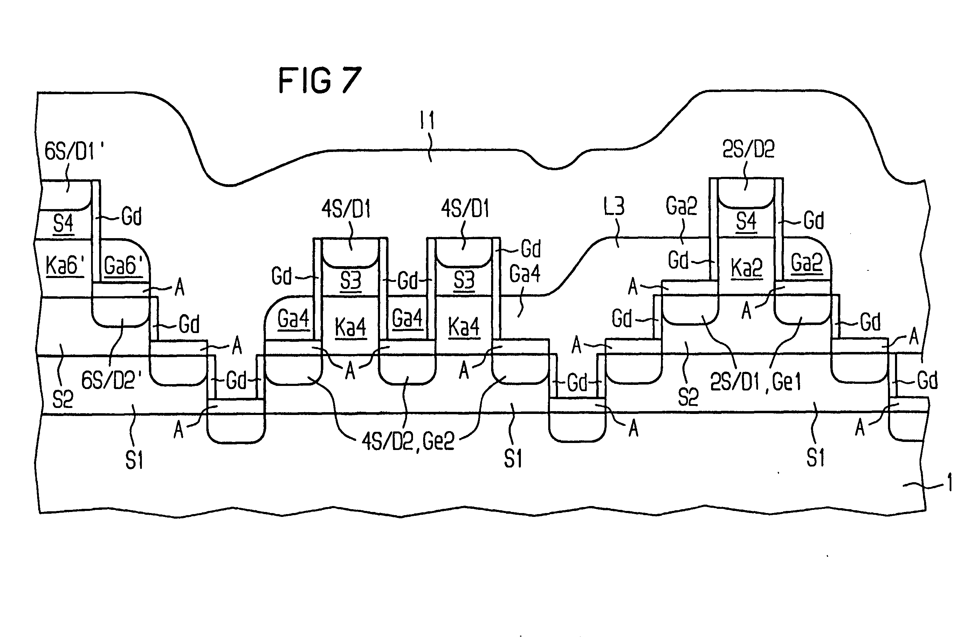

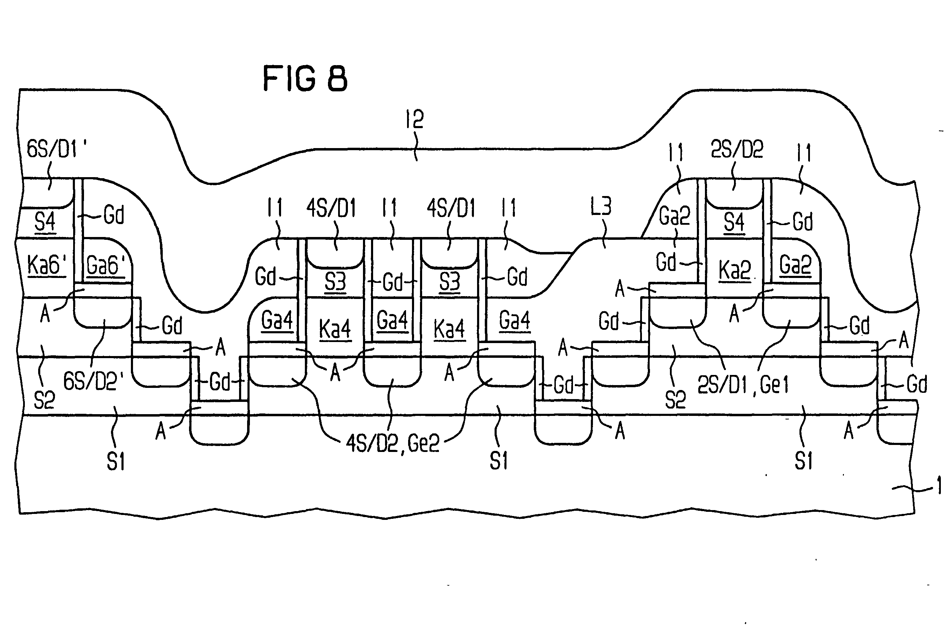

Zur Erzeugung einer ersten isolierenden Struktur I1, wird SiO₂ in einer Dicke von ca. 100nm abgeschieden und rückgeätzt, bis das erste Source/Drain-Gebiet des dritten Transistors, das erste Source/Drain-Gebiet 4S/D1 des vierten Transistors, das erste Source/Drain-Gebiet des sechsten Transistors, das erste Source/Drain-Gebiet des fünften Transistors, das zweite Source/Drain-Gebiet des ersten Transistors, das zweite Source/Drain-Gebiet 2S/D2 des zweiten Transistors, freigelegt werden (siehe Figur 7 und Figur 8). Um eventuell freigelegte Teile der dritten leitenden Struktur L3 und der fünften leitenden Struktur L5 zu isolieren, wird eine zweite isolierende Struktur I2 erzeugt, indem Siliziumnitrid in einer Dicke von ca. 100nm abgeschieden und mit Hilfe einer siebten Maske (nicht dargestellt), die das zweite Source/Drain-Gebiet des ersten Transistors, das zweite Source/Drain-Gebiet 2S/D2 des zweiten Transistors, die ersten Source/Drain-Gebiete des dritten Transistors, die ersten Source/Drain-Gebiete 4S/D1 des vierten Transistors, das erste Source/Drain-Gebiet des fünften Transistors, das erste Source/Drain-Gebiet des sechsten Transistors, Teile der ersten leitenden Struktur L1, Teile der zweiten leitenden Struktur L2 und Teile der vierten leitenden Struktur L4 nicht bedeckt, geätzt wird.

Anschließend wird eine selektive Silizierung durchgeführt, wodurch an freiliegenden Flächen aus Silizium Silizidschichten S entstehen.

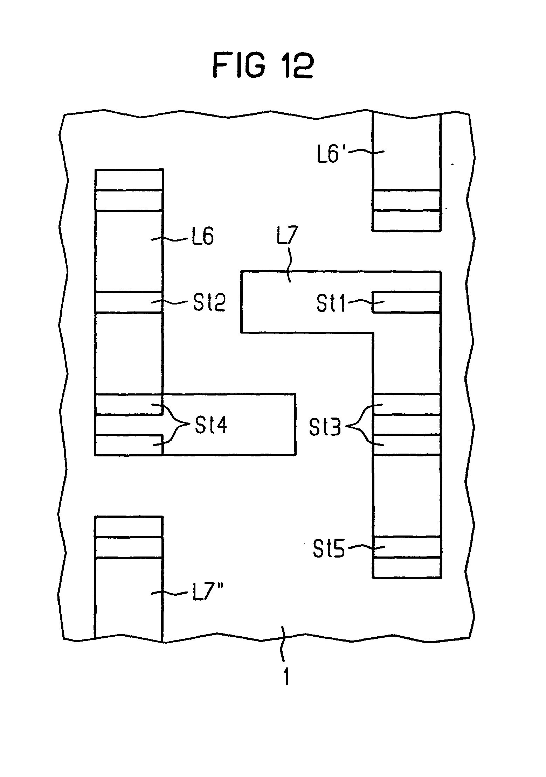

Anschließend wird Aluminium in einer Dicke von ca. 300nm abgeschieden und strukturiert, wodurch eine L-förmige sechste leitende Struktur L6, eine L-förmige siebte leitende Struktur L7 und ein unterer Teil eines ersten Kontakts K1, K1', der an die erste leitende Struktur L1, L1' angrenzt, erzeugt werden. Die sechste leitende Struktur L6 verbindet das erste Source/Drain-Gebiet des sechsten Transistors, das zweite Source/Drain-Gebiet 2 S/D2 des zweiten Transistors, die ersten Source/Drain-Gebiete 4 S/D1 des vierten Transistors und die vierte leitende Struktur L4 miteinander. Die siebte leitende Struktur L7 verbindet die zweite leitende Struktur L2, das zweite Source/Drain-Gebiet des ersten Transistors, die ersten Source/Drain-Gebiete des dritten Transistors und das erste Source/Drain-Gebiet des fünften Transistors miteinander (siehe Figur 12).

Anschließend wird eine dritte isolierende Struktur I3 erzeugt, indem SiO₂ in einer Dicke von ca. 300nm aufgebracht wird. Durch Ätzen mit z.B. CHF₃/O₂ wird ein Kontaktloch, das bis auf den unteren Teil des ersten Kontakts K1, K1' reicht, erzeugt. Anschließend wird Aluminium abgeschieden und strukturiert, wodurch im Kontaktloch ein oberer Teil des ersten Kontakts K1, K1' und daran angrenzend eine parallel zur x-Achse x verlaufende Wortleitung W erzeugt werden (siehe Figur 11).

Im folgenden werden die Verbindungen zwischen Teilen der Transistoren der SRAM-Zellenanordnung des Ausführungsbeispiels zusammengefaßt: Das erste Source/Drain-Gebiet des ersten Transistors ist mit dem ersten Source/Drain-Gebiet des zweiten Transistors und dem ersten Spannungsanschluß verbunden. Das zweite Source/Drain-Gebiet des ersten Transistors ist mit dem ersten Source/Drain-Gebiet des dritten Transistors, dem ersten Source/Drain-Gebiet des fünften Transistors, der zweiten Gateelektrode und der vierten Gateelektrode verbunden. Die erste Gateelektrode ist mit dem zweiten Source/Drain-Gebiet des zweiten Transistors, dem ersten Source/Drain-Gebiet des vierten Transistors, der dritten Gateelektrode und dem ersten Source/Drain-Gebiet des sechsten Transistors verbunden. Das zweite Source/Drain-Gebiet des dritten Transistors ist mit dem zweiten Source/Drain-Gebiet des vierten Transistors und dem zweiten Spannungsanschluß verbunden. Das zweite Source/Drain-Gebiet des fünften Transistors ist mit der ersten Bitleitung verbunden. Die fünfte Gateelektrode ist mit einer sechsten Gateelektrode und mit der Wortleitung verbunden. Das zweite Source/Drain-Gebiet des sechsten Transistors ist mit der zweiten Bitleitung verbunden. Der dritte Transistor und der vierte Transistor sind komplementär zum ersten Transistor, zum zweiten Transistor, zum fünften Transistor und zum sechsten Transistor.

Es sind viele Variationen des Ausführungsbeispiels denkbar, die ebenfalls im Rahmen der Erfindung liegen. Insbesondere können die Abmessungen der beschriebenen Schichten, Gebiete, Masken und Strukturen an die jeweiligen Erfordernisse angepaßt werden. Dasselbe gilt auch für die vorgeschlagenen Dotierstoffkonzentrationen. Die Halbleiterstruktur muß nicht stegförmig sein, sondern kann an die jeweiligen Erfordernisse angepaßt werden. Die Flanken der Halbleiterstruktur müssen nicht senkrecht zur Oberfläche der Halbleiterstruktur verlaufen, sondern können mit der Oberfläche der Halbleiterstruktur einen beliebigen Winkel einschließen. Bitleitung und Wortleitung müssen nicht senkrecht zueinander verlaufen, sondern können beliebige Winkel einschließen. Masken und Schichten aus SiO₂ können durch thermische Oxidation oder durch ein Abscheidungsverfahren erzeugt werden. Polysilizium kann sowohl während als auch nach der Abscheidung dotiert werden. Statt dotiertem Polysilizium lassen sich auch z.B. Metallsilizide und/oder Metalle verwenden.

## Patentansprüche

1. SRAM-Zellenanordnung,
- mit Speicherzellen, die jeweils mindestens einen ersten Transistor (St1), einen zweiten Transistor (St2), einen dritten Transistor (St3), einen vierten Transistor (St4), einen fünften Transistor (St5) und einen sechsten Transistor (St6) umfasst,
- bei der der erste Transistor (St1), der zweite Transistor (St2), der dritte Transistor (St3) und der vierte Transistor (St4) eine Flip-Flop-Schaltung bilden, die über den fünften Transistor (St5) und über den sechsten Transistor (St6) angesteuert wird und die zwischen einen ersten Spannungsanschluß und einen zweiten Spannungsanschluß geschaltet ist,
- bei der der dritte Transistor (St3) und der vierte Transistor (St4) komplementär zum ersten Transistor (St1) und zum zweiten Transistor (St2) sind,
- bei der der fünfte Transistor (St5) und der sechste Transistor (St6) über eine Wortleitung (W) angesteuert werden,
- bei der ein zweites Source/Drain-Gebiet des fünften Transistors (St5) mit einer ersten Bitleitung (B1) verbunden ist,
- bei der ein zweites Source/Drain-Gebiet des sechsten Transistors (St6) mit einer zweiten Bitleitung (B2) verbunden ist,
- bei der die erste Bitleitung (B1) und die zweite Bitleitung (B2) quer zur Wortleitung (W) verlaufen,
- bei der der erste Transistor (St1), der zweite Transistor (St2), der dritte Transistor (St3) und der vierte Transistor (St4) an Ecken eines Vierecks angeordnet sind, so dass die Ecke, an der der erste Transistor angeordnet ist, und die Ecke, an der der vierte Transistor (St4) angeordnet ist, sich diagonal gegegenüberliegen,
- bei der der dritte Transistor (St3) zwischen dem ersten Transistor (St1) und dem fünften Transistor (St5) angeordnet ist,
- bei der der zweite Transistor (St2) zwischen dem vierten Transistor (St4) und dem sechsten Transistor (St6) angeordnet ist
- bei der eine Verbindungslinie zwischen der Ecke, an der der erste Transistor (St1) angeordnet ist, und der Ecke, an der zweite Transistor (St2) angeordnet ist, parallel zu einer z-Achse (z), die quer zur Wortleitungrichtung verläuft, verläuft,
- bei der eine Verbindungslinie zwischen der Ecke, an der der dritte Transistor (St3) angeordnet ist, und der Ecke, an der der vierte Transistor (St4) angeordnet ist, parallel zur z-Achse (z) verläuft,
**gekennzeichnet durch** eine SRAM-Zellenanordnung
- bei der der erste Transistor (St1), der dritte Transistor (St3) und der fünfte Transistor (St5) in Wortleitungsrichtung nebeneinander angeordnet sind,
- bei der der zweite Transistor (St2), der vierte Transistor (St4) und der sechste Transistor (St6) in Wortleitungsrichtung nebeneinander angeordnet sind,
- bei der eine Verbindungslinie zwischen dem sechsten Transistor (St6) einer ersten Speicherzelle un dem fünften Transistor (St5) einer zweiten Speicherzelle, die entlang der Wortleitung (w) zur ersten speichezelle benachbart ist, parallel zur z-Achse (z) verläuft,
- bei der die erste Speicherzelle und die zweite Speicherzelle translationssymmetrisch oder um 180° rotationssymmetrisch zueinander aufgebaut sind,
- bei der die Wortleitung (W) zwischen dem sechsten Transistor (St6) der ersten Speicherzelle und dem fünften Transistor (St5) der zweiten Speicherzelle angeordnet ist,
- bei der die eine Gateelektrode (Ga6) des sechsten Transistors (St6) der ersten Speicherzelle und eine Gateelektrode (Ga5'') des fünften Transistors (St5) der zweiten Speicherzelle über eine erste leitende Struktur (L1) miteinander verbunden sind,
- bei der die erste leitende Struktur (L1) über einen ersten Kontakt (K1) mit der Wortleitung (Wl) verbunden sind.

2. SRAM-Zellenanordnung nach Anspruch 1,
- bei der Kanalweiten von p-Kanal-Transistoren (Ka3, Ka4) etwa doppelt so groß wie Kanalweiten von n-Kanal-Transistoren (Ka1, Ka2, Ka5, Ka6) sind.

3. SRAM-Zellenanordnung nach Anspruch 1 oder 2,
- bei der der erste Transistor (St1), der zweite Transistor (St2), der dritte Transistor (St3), der vierte Transistor (St4) und/oder der sechste Transistor (St6) vertikale MOS-Transistoren sind.

4. SRAM-Zellenanordnung nach Anspruch 3,
- bei der der erste Transistor (St1), der zweite Transistor (St2), der dritte Transistor (St3) und der vierte Transistor (St4) vertikale MOS-Transistoren sind,
- bei der Höhen bezüglich einer y-Achse (y), die senkrecht zu einer Oberfläche (O) eines Substrats (1) verläuft, von Kanalgebieten des dritten Transistors und des vierten Transistors miteinander übereinstimmen,
- bei der Höhen bezüglich der y-Achse (y) von Kanalgebieten des ersten Transistors und die Höhe des Kanalgebiets des dritten Tansistors unterschiedlich sind.
- bei der die Höhe des Kanalgebiets des ersten Transistors und die Höhe des Kanalgebiets des dritten transistors unterschiedlich sind.

5. SRAM-Zellenanordnung nach einem der Ansprüche 1 bis 4,
- bei der das zweite Source/Drain-Gebiet des fünften Transistors (St5) als Teil der ersten Bitleitung (B1) ausgebildet ist,
- bei der das zweite Source/Drain-Gebiet des sechsten Transistors (St6) als Teil der zweiten Bitleitung (B2) ausgebildet ist,
- bei der die erste Bitleitung (B1) und die zweite Bitleitung (B2) jeweils streifenförmig und im Substrat angeordnet sind,
- bei der das erste Source/Drain-Gebiet des ersten Transistors (St1) mit dem ersten Source/Drain-Gebiet (2 S/D1) des zweiten Transistors und dem ersten Spannungsanschluß über ein im Substrat (1) angeordnetes, streifenförmiges dotiertes erstes Gebiet (Ge1) verbunden ist,
- bei der das zweite Source/Drain-Gebiet des dritten Transistors (St3) mit dem zweiten Source/Drain-Gebiet (4 S/D2)des vierten Transistors und dem zweiten Spannungsanschluß über ein im Substrat (1) angeordnetes, streifenförmiges zweites dotiertes Gebiet (Ge2) verbunden ist,
- bei der das erste dotierte Gebiet (Ge1), das zweite dotierte Gebiet (Ge2), die erste Bitleitung (B1) und die zweite Bitleitung (B2) im wesentlichen parallel zur z-Achse (z) verlaufen.

6. Verfahren zur Herstellung einer SRAM-Zellenanordnung,
- bei dem Speicherzellen, die jeweils einen ersten Transistor (St1), einen zweiten Transistor (St2), einen dritten Transistor (St3), einen vierten Transistor (St4), einen fünften Transistor (St5) und einen sechsten Transistor (St6) umfassen, erzeugt werden,
- bei der der erste Transistor (St1), der zweite Transistor (St2), der dritte Transistor (St3), der vierte Transistor (St4), der fünfte Transistor (St5) und der sechste Transistor (St6) so miteinander verbunden werden, dass der erste Transistor (St1), der zweite Transistor (St2), der dritte Transistor (St3) und der vierte Transistor (St4) eine Flip-Flop-Schaltung bilden, die über den fünften Transistor (St5) und über den sechsten Transistor (St6)angesteuert wird,
- bei dem die Flip-Flop-Schaltung mit einem ersten Spannungsanschluß und einem zweiten Spannungsanschluß verbunden wird,
- bei dem der dritte Transistor (St3) und der vierte Transistor (St4) als zum ersten Transistor (St1)und zum zweiten Transistor (St2) komplementäre Transistoren ausgebildet werden,
- bei dem eine Wortleitung (W) erzeugt wrid, die den fünften Transistor (St5) und den sechsten Transistor (St6) angesteuert,
- bei dem ein zweites Source/Drain-Gebiet des fünften Transistors (St5) mit einer ersten Bitleitung (B1) verbunden wird, die quer zur Wortleitung (W) verläuft,
- bei dem ein zweites Source/Drain-Gebiet des sechsten Transistors (St6) mit einer zweiten Bitleitung (B2) verbunden wird, die quer zur Wortleitung (W) verläuft,
- bei dem der erste Transistor (St1), der zweite Transistor (St2), der dritte Transistor (St3) und der vierte Transistor (St4) an Ecken eines Vierecks erzeugt werden, so dass die Ecke, an der der erste Transistor (St1) angeordnet ist, und die Ecke, an der der vierte Transistor (St4) angeordnet ist, sich diagonal gegenüberliegen,
- bei dem der dritte Transistor (St3) zwischen dem ersten Transistor (St1)und dem fünften Transistor (St5) erzeugt wird,
- bei dem der zweite Transistor (St2) zwischen dem vierten Transistor (St4) und dem sechsten Transistor (St6) erzeugt wird,
- bei dem der erste Transistor (St1) und der zweite Transistor (St2) so erzeugt werden, dass eine Verbindungslinie zwischen der Ecke, an der der erste Transistor (St1) erzeugt wird, und der Ecke, an der der zweite Transistor (St2)erzeugt wird, parallel zu einer z-Achse (z), die quer zur Wortleitungsrichtung verläuft, verläuft,
- bei dem der dritte Transistor (St3) und der vierte Transistor (St4) so erzeugt werden, dass eine Verbindungslinie zwischen der Ecke, an der der dritte Transistor (St3) erzeugt wird, und der Ecke, an der der vierte Transistor (St4) erzeugt wird, parallel zur z-Achse (z) verläuft,
**gekennzeichnet durch** ein Verfahren
- bei dem der erste Transistor (St1), der dritte Transistor (St3) und der fünfte Transistor (St5) so erzeugt werden, dass sie in Wortleitungsrichtung nebeneinander angeordnet sind,
- bei dem der zweite Transistor (St2), der vierte Transistor (St4) und der sechste Transistor (St6) so erzeugt werden, dass sie in Wortleitungrichtung nebeneinander angeordnet sind,
- bei dem die Speicherzellen so erzeugt werden, dass eine Verbindungslinie zwischen dem sechsten Transistor (St6) einer ersten Speicherzelle und dem fünften Transistor (St5) einer zweiten Speicherzelle, die entlang der Worleitung (W) zur ersten Speicherzelle benachtbart ist, parallel zur z-Achse (z) verläuft,
- bei dem die erste Speicherzelle und die zweite Speicherzelle so erzeugt werden, dass sie translationssymmetrisch oder um 180° rotationssymmetrisch zueinander aufgebaut sind,
- bei dem die Wortleitung (W) zwischen dem sechsten Transistor (St6) der ersten Speicherzelle und dem fünften Transistor (St5) der zweiten Speicherzell ausgebildet wird,
- bei dem eine erste leitende Struktur (L1) erzeugt wird, die eine Gateelektrode (Ga6) des sechsten Transistors (St6) der ersten Speicherzelle und eine Gateelektrode (Ga5'') des fünften Transistors (St5) der zweiten Speicherzelle miteinander verbindet,
- bei dem ein erster Kontakt (K1) erzeugt wird, der die erste leitende Struktur (L1) mit der Wortleitung (W) verbindet.

7. Verfahren nach Anspruch 6,
- bei dem der erste Transistor (St1), der zweite Transistor (St2), der dritte Transistor (St3), der vierte Transistor (St4), der fünfte Transistor (St5) und der sechste Transistor (St6) so erzeugt werden, dass Kanalweiten von p-Kanal-Transistoren (Ka3, Ka4) doppelt so groß wie Kanalweiten von n-Kanal-Transistoren (Ka1, Ka2, Ka5, Ka6) sind.

8. Verfahren nach Anspruch 6 oder 7,
- bei dem der erste Transistor (St1), der zweite Transistor (St2), der dritte Transistor (St3), der vierte Transistor (St4), der fünfte Transistor (St5) und/oder der sechste Transistor (St6) als vertikale MOS-Transistoren ausgebildet werden.

9. Verfahren nach Anspruch 8,
- bei dem der erste Transistor (St1), der zweite Transistor (St2), der dritte Transistor (St3) und der vierte Transistor (St4) als vertikale MOS-Transistoren ausgebildet werden,
- bei dem eine Schichtenfolge, mit mindestens einer von einem ersten Leitfähigkeitstyp dotierten ersten Schicht (S1), einer darüberliegenden von einem zweiten, zum ersten Leitfähigkeitstyp entgegengesetzten Leithäfigkeitstyp dotierten zweiten Schicht (S2), einer darüberliegenden vom ersten Leitfähigkeitstyp dotierten dritten Schicht (S3) und einer darüberliegenden vom zweiten Leitfähigkeitstyp dotierten vierten Schicht (S4), erzeugt wird,
- bei dem durch mehrstufiges maskiertes Ätzen der Schichtenfolge Halbleiterstrukturen (St1, St2, St3, St4) erzeugt werden, an denen mindestens der erste Transistor (St1), der zweite Transistor (St2), der dritte Transistor (St3) und der vierte Transistor (St4) ausgebildet werden,
- bei dem aus der zweiten Schicht (S2) und aus der dritten Schicht (S3) Kanalgebiete entstehen, so dass Höhen bezüglich einer y-Achse (y), die senkrecht zu einer Oberfläche (O) eines Substrats (1) verläuft, von Kanalgebieten des dritten Transistors (St3) und des vierten Transistors (St4) miteinander übereinstimmen, Höhen bezüglich der y-Achse (y) von Kanalgebiten des ersten Transistors (St1) und des zweiten Transistors (St2) miteinander übereinstimmen und die Höhe des Kanalgebiets des ersten Transistors (St1) und die Höhe des Kanalgebiets des dritten Transistors (St3) unterschiedlich sind.

10. Verfahren nach Anspruch 9,
- bei dem das erste Source/Drain-Gebiet des ersten Transistors (St1) und das erste Source/Drain-Gebiet (2 S/D1) des zweiten Transistors (St2) als Teile eines streifenförmigen ersten dotierten Gebiets (Ge1) erzeugt werden,
- bei dem das zweite Source/Drain-Gebiet des dritten Transistors (St3) und das zweite Source/Drain-Gebiet (4 S/D2) des vierten Transistors (St4) als Teile eines streifenförmigen dotierten zweiten Gebiets (Ge2) erzeugt werden,
- bei dem das zweite Source/Drain-Gebiet des fünften Transistors (St5), das zweite Source/Drain-Gebiet des sechsten Transistors (St6), die erste Bitleitung (B1), die zweite Bitleitung(B2) und das erste dotierte Gebiet (Ge1) in der zweiten Schicht (S2) oder in der erste Schicht (S1) gebildet werden,
- bei dem das zweite dotierte Gebiet (Ge2) in der ersten Schicht (S1) oder in der zweiten Schicht (S2) erzeugt wird
- bei dem das zweite dotierte Gebiet (Ge2) nicht in der Schicht, in der das erste dotierteGebiet (Ge1) erzeugt wird, erzeugt wird.

11. Verfahren nach Anspruch 9 oder 10,
- bei dem nach Erzeugung der Schichtenfolge eine erste Hilfsschicht (H1) abgeschieden wird,
- bei dem in die erste Hilfsschicht (H1) parallel zur z-Achse (z) verlaufende Gräben erzeugt werden,
- bei dem durch Abscheiden und Rückätzen von Material an Flanken der Gräben Spacer (Sp) entstehen,
- bei dem mit Hilfe einer Maske, die streifenförmige, parallel zur Wortleitung (W) verlaufende Bereiche bedeckt, geätzt wird, wodurch aus den Spacern (Sp) eine erste Maske (M1) entsteht,
- bei dem mit Hilfe der ersten Maske durch Ätzen der Schichtenfolge mindestens die Halbleiterstrukturen (St1, St2, St3, St4) erzeugt werden, an denen mindestens der erste Transistor (St1) und der zweite Transistor (St2) oder der dritte Transistor (St3) und der vierte Transistor (St4) ausgebildet werden.

12. Verfahren nach einem der Ansprüche 6 bis 11,
- bei dem für den ersten Transistor (St1), den zweiten Transistor (St2), den dritten Transistor (St3), den vierten Transistor (St4), den fünften Transistor (St5) und den sechsten Transistor (St6) jeweils mindestens eine Halbleiterstruktur (St1, St2, St3, St4, St5, St6) erzeugt wird,
- bei dem nach Erzeugung eines Gatedielektrikums (Gd) leitendes Material abgeschieden und mit Hilfe einer sechsten Maske geätzt wird, die Bereiche zwischen den Transistoren derart bedeckt, daß
a) Gateelektroden (Ga1, Ga2, G3, Ga4, Ga5, Ga6) der Transistoren, die die zugehörigen Halbleiterstrukturen (St1, St2, St3, St4, St5, St6) umgeben,
b) die erste leitende Struktur (L1)
c) zwischen dem ersten Transistor (St1) und dem zweiten Transistor (St2) eine zweite leitende Struktur (L2), die eine Gateelektrode (Ga2) des zweiten Transistors (St2) überlappt,
d) zwischen dem zweiten Transistor (St2) und dem vierten Transistor (St4)eine dritte leitende Struktur (L3), die die Gateelektrode (Ga2) des zweiten Transistors (St2) und eine Gateelektrode (Ga4) des vierten Transistors überlappt,
e) zwischen dem dritten Transistor (St3) und dem vierten Transistor (St4) eine vierte leitende Struktur (L4), die die eine Gateelektrode (Ga3) des dritten Transistors überlappt,
f) zwischen dem ersten Transistor (St1) und dem dritten Transistor (St3) eine fünfte leitende Struktur (L5), die die eine Gateelektrode (Ga3) des dritten Transistors (St3) überlappt, erzeugt werden.

## Claims

1. SRAM cell arrangement,
- having memory cells each comprising at least a first transistor (St1), a second transistor (St2), a third transistor (St3), a fourth transistor (St4), a fifth transistor (St5) and a sixth transistor (St6),
- in which the first transistor (St1), the second transistor (St2), the third transistor (St3) and the fourth transistor (St4) form a flip-flop circuit which is driven via the fifth transistor (St5) and via the sixth transistor (St6) and is connected between a first voltage terminal and a second voltage terminal,
- in which the third transistor (St3) and the fourth transistor (St4) are complementary to the first transistor (St1) and to the second transistor (St2),
- in which the fifth transistor (St5) and the sixth transistor (St6) are driven via a word line (W),
- in which a second source/drain region of the fifth transistor (St5) is connected to a first bit line (B1),
- in which a second source/drain region of the sixth transistor (St6) is connected to a second bit line (B2),
- in which the first bit line (B1) and the second bit line (B2) run transversely with respect to the word line (W),
- in which the first transistor (St1), the second transistor (St2), the third transistor (St3) and the fourth transistor (St4) are arranged at corners of a quadrilateral, so that the corner at which the first transistor is arranged and the corner at which the fourth transistor (St4) is arranged are situated diagonally opposite one another,
- in which the third transistor (St3) is arranged between the first transistor (St1) and the fifth transistor (St5),
- in which the second transistor (St2) is arranged between the fourth transistor (St4) and the sixth transistor (St6),
- in which a connecting line between the corner at which the first transistor (St1) is arranged and the corner at which the second transistor (St2) is arranged runs parallel to a z-axis (z), which runs transversely with respect to the word line direction,
- in which a connecting line between the corner at which the third transistor (St3) is arranged and the corner at which the fourth transistor (St4) is arranged runs parallel to the z-axis (z),
**characterized by** an SRAM cell arrangement
- in which the first transistor (St1), the third transistor (St3) and the fifth transistor (St5) are arranged next to one another in the word line direction,
- in which the second transistor (St2), the fourth transistor (St4) and the sixth transistor (St6) are arranged next to one another in the word line direction,
- in which a connecting line between the sixth transistor (St6) of a first memory cell and the fifth transistor (St5) of a second memory cell, which is adjacent to the first memory cell along the word line (W) runs parallel to the z-axis (z),
- in which the first memory cell and the second memory cell are constructed such that they are translationally symmetrical or rotationally symmetrical through 180° relative to one another,
- in which the word line (W) is arranged between the sixth transistor (St6) of the first memory cell and the fifth transistor (St5) of the second memory cell,
- in which the one gate electrode (Ga6) of the sixth transistor (St6) of the first memory cell and a gate electrode (Ga5") of the fifth transistor (St5) of the second memory cell are connected to one another via a first conductive structure (L1),
- in which the first conductive structure (L1) is connected to the word line (Wl) via a first contact (K1).

2. SRAM cell arrangement according to Claim 1,
- in which channel widths of p-channel transistors (Ka3, Ka4) are about twice as large as channel widths of n-channel transistors (Ka1, Ka2, Ka5, Ka6).

3. SRAM cell arrangement according to Claim 1 or 2,
- in which the first transistor (St1), the second transistor (St2), the third transistor (St3), the fourth transistor (St4) and/or the sixth transistor (St6) are vertical MOS transistors.

4. SRAM cell arrangement according to Claim 3,
- in which the first transistor (St1), the second transistor (St2), the third transistor (St3) and the fourth transistor (St4) are vertical MOS transistors,
- in which heights with regard to a y-axis (y), which runs perpendicularly to a surface (O) of a substrate (1), of channel regions of the third transistor and of the fourth transistor correspond to one another,
- in which heights with regard to the y-axis (y) of channel regions of the first transistor and the height of the channel region of the third transistor are different,
- in which the height of the channel region of the first transistor and the height of the channel region of the third transistor are different.

5. SRAM cell arrangement according to one of Claims 1 to 4,
- in which the second source/drain region of the fifth transistor (St5) is designed as part of the first bit line (B1),
- in which the second source/drain region of the sixth transistor (St6) is designed as part of the second bit line (B2),
- in which the first bit line (B1) and the second bit line (B2) are in each case in the form of a strip and are arranged in the substrate,
- in which the first source/drain region of the first transistor (St1) is connected to the first source/drain region (2 S/D1) of the second transistor and to the first voltage terminal via a doped first region (Ge1), which is in the form of a strip and is arranged in the substrate (1),
- in which the second source/drain region of the third transistor (St3) is connected to the second source/drain region (4 S/D2) of the fourth transistor and to the second voltage terminal via a second doped region (Ge2) which is in the form of a strip and is arranged in the substrate (1),
- in which the first doped region (Ge1), the second doped region (Ge2), the first bit line (B1) and the second bit line (B2) run essentially parallel to the z-axis (z).

6. Method for fabricating an SRAM cell arrangement,
- in which memory cells each comprising a first transistor (St1), a second transistor (St2), a third transistor (St3), a fourth transistor (St4), a fifth transistor (St5) and a sixth transistor (St6) are produced,
- in which the first transistor (St1), the second transistor (St2), the third transistor (St3), the fourth transistor (St4), the fifth transistor (St5) and the sixth transistor (St6) are connected to one another in such a way that the first transistor (St1), the second transistor (St2), the third transistor (St3) and the fourth transistor (St4) form a flip-flop circuit which is driven via the fifth transistor (St5) and via the sixth transistor (St6),
- in which the flip-flop circuit is connected to a first voltage terminal and to a second voltage terminal,
- in which the third transistor (St3) and the fourth transistor (St4) are designed as transistors which are complementary to the first transistor (St1) and to the second transistor (St2),
- in which a word line (W) is produced which drives the fifth transistor (St5) and the sixth transistor (St6),
- in which a second source/drain region of the fifth transistor (St5) is connected to a first bit line (B1), which runs transversely with respect to the word line (W),
- in which a second source/drain region of the sixth transistor (St6) is connected to a second bit line (B2), which runs transversely with respect to the word line (W),
- in which the first transistor (St1), the second transistor (St2), the third transistor (St3) and the fourth transistor (St4) are produced at corners of a quadrilateral, so that the corner at which the first transistor (St1) is arranged and the corner at which the fourth transistor (St4) is arranged situated diagonally opposite one another,
- in which the third transistor (St3) is produced between the first transistor (St1) and the fifth transistor (St5),
- in which the second transistor (St2) is produced between the fourth transistor (St4) and the sixth transistor (St6),
- in which the first transistor (St1) and the second transistor (St2) are produced in such a way that a connecting line between the corner at which the first transistor (St1) is produced and the corner at which the second transistor (St2) is produced runs parallel to a z-axis (z), which runs transversely with respect to the word line direction,
- in which the third transistor (St3) and the fourth transistor (St4) are produced in such a way that a connecting line between the corner at which the third transistor (St3) is produced and the corner at which the fourth transistor (St4) is produced runs parallel to the z-axis (z),
**characterized by** a method
- in which the first transistor (St1), the third transistor (St3) and the fifth transistor (St5) are produced in such a way that they are arranged next to one another in the word line direction,
- in which the second transistor (St2), the fourth transistor (St4) and the sixth transistor (St6) are produced in such a way that they are arranged next to one another in the word line direction,
- in which the memory cells are produced in such a way that a connecting line between the sixth transistor (St6) of a first memory cell and the fifth transistor (St5) of a second memory cell, which is adjacent to the first memory cell along the word line (W), runs parallel to the z-axis (z),
- in which the first memory cell and the second memory cell are produced in such a way that they are constructed to be translationally symmetrical or rotationally symmetrical through 180° relative to one another,
- in which the word line (W) is formed between the sixth transistor (St6) of the first memory cell and the fifth transistor (St5) of the second memory cell,
- in which a first conductive structure (L1) is produced which connects a gate electrode (Ga6) of the sixth transistor (St6) of the first memory cell and a gate electrode (Ga5'') of the fifth transistor (St5) of the second memory cell to one another,
- in which a first contact (K1) is produced which connects the first conductive structure (L1) to the word line (W).

7. Method according to Claim 1,
- in which the first transistor (St1), the second transistor (St2), the third transistor (St3), the fourth transistor (St4), the fifth transistor (St5) and the sixth transistor (St6) are produced in such a way that channel widths of p-channel transistors (Ka3, Ka4) are about twice as large as channel widths of n-channel transistors (Ka1, Ka2, Ka5, Ka6).

8. Method according to Claim 6 or 7,
- in which the first transistor (St1), the second transistor (St2), the third transistor (St3), the fourth transistor (St4), the fifth transistor (St5), and/or the sixth transistor (St6) are designed as vertical MOS transistors.

9. Method according to Claim 8,
- in which the first transistor (St1), the second transistor (St2), the third transistor (St3) and the fourth transistor (St4) are designed as vertical MOS transistors,
- in which a layer sequence is produced, having at least a first layer (S1), which is doped by a first conductivity type, a second layer (S2) which lies above said first layer and is doped by a second conductivity type, opposite to the first conductivity type, a third layer (S3) which lies above said second layer and is doped by the first conductivity type, and a fourth layer (S4) which lies above said third layer and is doped by the second conductivity type,
- in which multistage masked etching of the layer sequence produces semiconductor structures (St1, St2, St3, St4), on which at least the first transistor (St1), the second transistor (St2), the third transistor (St3) and the fourth transistor (St4) are formed,
- in which channel regions are produced from the second layer (S2) and from the third layer (S3), so that heights with regard to a y-axis (y), which runs perpendicularly to a surface (0) of a substrate (1), of channel regions of the third transistor (St3) and of the fourth transistor (St4) correspond to one another, heights with regard to the y-axis (y) of channel regions of the first transistor (St1) and of the second transistor (St2) correspond to one another, and the height of the channel region of the first transistor (St1) and the height of the channel region of the third transistor (St3) are different.

10. Method according to Claim 9,
- in which the first source/drain region of the first transistor (St1) and the first source/drain region (2 S/D1) of the second transistor (St2) are produced as parts of a first doped region (Ge1) in the form of a strip,
- in which the second source/drain region of the third transistor (St3) and the second source/drain region (4S/D2) of the fourth transistor (St4) are produced as parts of a doped second region (Ge2) in the form of a strip,
- in which the second source/drain region of the fifth transistor (St5), the second source/drain region of the sixth transistor (St6), the first bit line (B1), the second bit line (B2) and the first doped region (Ge1) are formed in the second layer (S2) or in the first layer (S1),
- in which the second doped region (Ge2) is produced in the first layer (S1) or in the second layer (S2),
- in which the second doped region (Ge2) is not produced in the layer in which the first doped region (Ge1) is produced.

11. Method according to Claim 9 or 10,
- in which after the production of the layer sequence, a first auxiliary layer (H1) is deposited,
- in which trenches running into the first auxiliary layer (H1) parallel to the z-axis (z) are produced,
- in which spacers (Sp) are produced by depositing and etching back material on sidewalls of the trenches,
- in which etching is carried out with the aid of a mask which covers regions in strip form running parallel to the word line (W), as a result of which a first mask (M1) is produced from the spacers (Sp),
- in which at least the semiconductor structures (St1, St2, St3, St4) are produced with the aid of the first mask by etching of the layer sequence, on which semiconductor structures at least the first transistor (St1) and the second transistor (St2) or the third transistor (St3) and the fourth transistor (St4) are formed.

12. Method according to one of Claims 6 to 11,
- in which at least one semiconductor structure (St1, St2, St3, St4, St5, St6) is produced in each case for the first transistor (St1), the second transistor (St2), the third transistor (St3), the fourth transistor (St4), the fifth transistor (St5) and the sixth transistor (St6),
- in which after the production of a gate dielectric (Gd), conductive material is deposited and etched with the aid of a sixth mask, which covers regions between the transistors in such a way that the following are produced:
a) gate electrodes (Ga1, Ga2, Ga3, Ga4, Ga5, Ga6) of the transistors, which surround the associated semiconductor structures (St1, St2, St3, St4, St5, St6),
b) the first conductive structure (L1),
c) between the first transistor (St1) and the second transistor (St2) a second conductive structure (L2), which overlaps a gate electrode (Ga2) of the second transistor (St2),
d) between the second transistor (St2) and the fourth transistor (St4) a third conductive structure (L3), which overlaps the gate electrode (Ga2) of the second transistor (St2) and a gate electrode (Ga4) of the fourth transistor,
e) between the third transistor (St3) and the fourth transistor (St4) a fourth conductive structure (L4), which overlaps the one gate electrode (Ga3) of the third transistor,
f) between the first transistor (St1) and the third transistor (St3) a fifth conductive structure (L5), which overlaps the one gate electrode (Ga3) of the third transistor (St3).

## Revendications

1. Réseau de cellules SRAM,
- comprenant des cellules de mémoire, qui comprennent, respectivement, au moins un premier transistor ( St1 ), un deuxième transistor ( St2 ), un troisième transistor ( St3 ), un quatrième transistor ( St4 ), un cinquième transistor ( St5 ) et un sixième transistor ( St6 ),
- dans lequel le premier transistor ( St1 ), le deuxième transistor ( St2 ), le troisième transistor ( St3 ), et le quatrième transistor ( St4 ) forment un circuit de bascule, qui est commandé par le cinquième transistor ( St5 ) et par le sixième transistor ( St6 ) et qui est monté entre une première borne de tension et une deuxième borne de tension,
- dans lequel le troisième transistor ( St3 ) et le quatrième transistor ( St4 ) sont complémentaires du premier transistor ( St1 ) et du deuxième transistor ( St2 ),
- dans lequel le cinquième transistor ( St5 ) et le sixième transistor ( St6 ) sont commandés par une ligne ( W ) de mots,
- dans lequel une deuxième zone de source/drain du cinquième transistor ( St5 ) est reliée à une première ligne ( B1 ) de bits,
- dans lequel une deuxième zone de source/drain du sixième transistor ( St6 ) est reliée à une deuxième ligne ( B2 ) de bits,
- dans lequel la première ligne ( B1 ) de bits et la deuxième ligne ( B2 ) de bits s'étendent transversalement à la ligne ( W ) de mots,
- dans lequel le premier transistor ( St1 ), le deuxième transistor ( St2 ), le troisième transistor ( St3 ) et le quatrième transistor ( St4 ) sont disposés aux sommets d'un quadrilatère, de sorte que le sommet où est disposé le premier transistor et le sommet où est disposé le quatrième transistor ( St4 ) sont opposés en diagonale,
- dans lequel le troisième transistor ( St3 ) est disposé entre le premier transistor ( St1 ) et le cinquième transistor ( St5 ),
- dans lequel le deuxième transistor ( St2 ) est disposé entre le quatrième transistor ( St4 ) et le sixième transistor ( St6 ),
- dans lequel une ligne de liaison s'étend entre le sommet où est disposé le premier transistor ( St1 ) et le sommet où est disposé le deuxième transistor ( St2 ), parallèlement à un axe z ( z ), qui s'étend transversalement à la direction de lignes de mots,
- dans lequel une ligne de liaison s'étend entre le sommet où est disposé le troisième transistor ( St3 ) et le sommet où est disposé le quatrième transistor ( St4 ), parallèlement à l'axe z ( z ),
**caractérisé par** un réseau de cellules SRAM,
- dans lequel le premier transistor ( St1 ), le troisième transistor ( St3 ) et le cinquième transistor ( St5 ) sont disposés côte à côte dans la direction de lignes de mots,
- dans lequel le deuxième transistor ( St2 ), le quatrième transistor ( St4 ) et le sixième transistor ( St6 ) sont disposés côte à côte dans la direction de lignes de mots,
- dans lequel une ligne de liaison s'étend entre le sixième transistor ( St6 ) d'une première cellule de mémoire et le cinquième transistor ( St5 ) d'une deuxième cellule de mémoire, qui est voisine de la première cellule voisine de mémoire le long de la ligne ( W ) de mots, parallèlement à l'axe z ( z ),
- dans lequel la première cellule de mémoire et la deuxième cellule de mémoire sont constituées en étant symétriques en translation ou symétriques en rotation de 180° l'une de l'autre,
- dans lequel la ligne ( W ) de mots est disposée entre le sixième transistor ( St6 ) de la première cellule de mémoire et le cinquième transistor ( St5 ) de la deuxième cellule de mémoire,
- dans lequel l'une des électrodes ( Ga6 ) de grille du sixième transistor ( St6 ) de la première cellule de mémoire et une électrode ( Ga5" ) de grille du cinquième transistor ( St5 ) de la deuxième cellule de mémoire sont reliées entre elles par une première structure ( L1 ) conductrice,
- dans lequel les premières structures ( L1 ) conductrices sont reliées à la ligne ( W1 ) de mots par un premier contact.

2. Réseau de cellules SRAM suivant la revendication 1,
- dans lequel des largeurs de canal de transistors ( Ka3, Ka4 ) à canal p sont à peu près deux fois plus grandes que des largeurs de canal de transistors ( Ka1, Ka2, Ka5, Ka6 ) à canal n.

3. Réseau de cellules SRAM suivant la revendication 1 ou 2,
- dans lequel le premier transistor ( St1 ), le deuxième transistor ( St2 ), le troisième transistor ( St3 ) et le quatrième transistor ( St4 ) et/ou le sixième transistor ( St6 ) sont des transistors MOS verticaux.

4. Réseau de cellules SRAM suivant la revendication 3,
- dans lequel le premier transistor ( St1 ), le deuxième transistor ( St2 ), le troisième transistor ( St3 ) et le quatrième transistor ( St4 ) sont des transistors MOS verticaux,
- dans lequel les hauteurs, par rapport à un axe y ( y ) qui s'étend perpendiculairement à une surface ( O ) d'un substrat ( 1 ), de zones de canal du troisième transistor et du quatrième transistor coïncident entre elles,
- dans lequel des hauteurs, par rapport à l'axe y ( y ), de zones de canal du premier transistor et la hauteur de la zone de canal du troisième transistor sont différentes,
- dans lequel la hauteur de la zone de canal du premier transistor et la hauteur de la zone de canal du troisième transistor sont différentes.

5. Réseau de cellules SRAM suivant l'une des revendications 1 à 4,
- dans lequel la deuxième zone de source/drain du cinquième transistor ( St5 ) fait partie de la première ligne (B1) de bits,
- dans lequel la deuxième zone de source/drain du sixième transistor ( St6 ) fait partie de la deuxième ligne ( B2 ) de bits,
- dans lequel la première ligne ( B1) de bits et la deuxième ligne ( B2 ) de bits sont disposées, respectivement, sous forme de bandes et dans le substrat,
- dans lequel la première zone de source/drain du premier transistor ( St1 ) est reliée à la première zone ( 2 S/D1 ) de source/drain du deuxième transistor et à la première borne de tension par une première zone ( Gel ) dopée en forme de bande et disposée dans le substrat ( 1 ),
- dans lequel la deuxième zone de source/drain du troisième transistor ( St3 ) est reliée à la deuxième zone ( 4 S/D2 ) de source/drain du quatrième transistor et à la deuxième borne de tension par une deuxième zone ( Ge2 ) dopée en forme de bande et disposée dans le substrat ( 1 ),
- dans lequel la première zone ( Ge1) dopée, la deuxième zone ( Ge2 ) dopée, la première ligne ( B1 ) de bits et la deuxième ligne ( B2 ) de bits s'étendent sensiblement parallèlement à l'axe z ( z ).

6. Procédé de production d'un réseau de cellules SRAM,
- dans lequel on produit des cellules de mémoire qui comprennent, respectivement, un premier transistor ( St1 ), un deuxième transistor ( St2 ), un troisième transistor ( St3 ), un quatrième transistor ( St4 ), un cinquième transistor ( St5 ) et un sixième transistor ( St6 ),
- dans lequel on relie entre eux le premier transistor ( St1 ), le deuxième transistor ( St2 ), le troisième transistor ( St3 ), le quatrième transistor ( St4 ), le cinquième transistor ( St5 ) et le sixième transistor ( St6 ) de façon à ce que le premier transistor ( St1 ), le deuxième transistor ( St2 ), le troisième transistor ( St3 ) et le quatrième transistor ( St4 ) forment un circuit de bascule qui est commandé par le cinquième transistor ( St5 ) et par le sixième transistor ( St6 ),
- dans lequel on relie le circuit de bascule à une première borne de tension et à une deuxième borne de tension,
- dans lequel on forme le troisième transistor ( St3 ) et le quatrième transistor ( St4 ) en tant que transistors complémentaires du premier transistor ( St1) et du deuxième transistor ( St2 ),
- dans lequel on produit une ligne ( W ) de mots, qui commande le cinquième transistor ( St5) et le sixième transistor ( St6 ),
- dans lequel on relie une deuxième zone de source/drain du cinquième transistor ( St5 ) à une première ligne ( B1 ) de bits, qui s'étend transversalement à la ligne de ( W ) de mots,
- dans lequel on relie une deuxième zone de source/drain du sixième transistor ( St6 ) à une deuxième ligne ( B2 ) de bits, qui s'étend transversalement à la ligne ( W ) de mots,
- dans lequel on produit le premier transistor ( St1 ), le deuxième transistor ( St2 ), le troisième transistor ( St3 ) et le quatrième transistor ( St4 ) aux sommets d'un quadrilatère, de sorte que le sommet où les disposé le premier transistor ( St1 ) et le sommet où est disposé le quatrième transistor ( St4 ) soient opposés en diagonale,
- dans lequel on produit le troisième transistor ( St3) entre le premier transistor ( St1 ) et le cinquième transistor ( St5 ),
- dans lequel on produit le deuxième transistor ( St2 ) entre le quatrième transistor ( St4 ) et le sixième transistor ( St6 ),
- dans lequel on produit le premier transistor ( St1 ) et le deuxième transistor ( St2 ) de façon à ce qu'une ligne de liaison, entre le sommet où est produit le premier transistor ( St1 ) et le sommet où est produit le deuxième transistor ( St2 ), s'étende parallèlement à un axe z ( z ) qui s'étend transversalement à la direction de lignes de mots,
- dans lequel on produit le troisième transistor ( St3 ) et le quatrième transistor ( St4 ) de façon à ce qu'une ligne de liaison s'étende, entre le sommet où est produit le troisième transistor ( St3 ) et le sommet où est produit le quatrième transistor ( St4 ), parallèlement à l'axe z ( z ),
**caractérisé par** un procédé
- dans lequel on produit le premier transistor ( St1 ), le troisième transistor ( St3 ) et le cinquième transistor ( St5 ) de façon à ce qu'ils soient disposés côte à côte dans la direction de ligne de mots,
- dans lequel on produit le deuxième transistor ( St2 ), le quatrième transistor ( St4 ) et le sixième transistor ( St6 ) de manière à ce qu'ils soient disposés côte à côte dans une direction de ligne de mots,
- dans lequel on produit les cellules de mémoire de façon à ce qu'une ligne de liaison s'étende, entre le sixième transistor ( St6 ) d'une première cellule de mémoire et le cinquième transistor ( St5 ) d'une deuxième cellule de mémoire, qui est voisine de la première cellule de mémoire le long de la ligne ( W ) de mots, parallèlement à l'axe z ( z ),
- dans lequel on produit la première cellule de mémoire et la deuxième cellule de mémoire de façon à ce qu'elles soient symétriques en translation ou symétriques en rotation de 180° l'une de l'autre,
- dans lequel on forme la ligne ( W ) de mots entre le sixième transistor ( St6 ) de la première cellule de mémoire et le cinquième transistor ( St5 ) de la deuxième cellule de mémoire,
- dans lequel on produit une première structure ( L1 ) conductrice qui relie entre elles une électrode ( Ga6 ) de grille du sixième transistor ( St6 ) de la première cellule de mémoire et une électrode ( Ga5" ) de grille du cinquième transistor ( St5 ) de la deuxième cellule de mémoire,
- dans lequel on produit un premier contact ( K1 ) qui relie la première structure ( L1 ) conductrice à la ligne ( W ) de mots.

7. Procédé suivant la revendication 6,
- dans lequel on produit le premier transistor ( St1 ), le deuxième transistor ( St2 ), le troisième transistor ( St3 ), le quatrième transistor ( St4 ), le cinquième transistor ( St5 ) et le sixième transistor ( St6 ) de manière à ce que des largeurs de canal de transistor ( Ka3, Ka4 ) à canal p soient deux fois plus grandes que les largeurs de canal de transistor ( Ka1, Ka2, Ka5, Ka6 ) à canal n.

8. Procédé suivant la revendication 6 ou 7,
- dans lequel on forme le premier transistor ( St1 ), le deuxième transistor ( St2 ), le troisième transistor ( St3 ), le quatrième transistor ( St4 ), le cinquième transistor ( St5 ) et/ou le sixième transistor ( St6 ) sous la forme de transistors MOS verticaux.

9. Procédé suivant la revendication 8,
- dans lequel on forme le premier transistor ( St1 ), le deuxième transistor ( St2 ), le troisième transistor ( St3 ) et le quatrième transistor ( St4 ) sous la forme de transistors MOS verticaux,
- dans lequel on produit une succession de couches, ayant au moins une première couche ( S1 ) dopée d'un premier type de conductivité, une deuxième couche ( S2 ) au-dessus et dopée par un deuxième type de conductivité opposé au premier type de conductivité, une troisième couche ( S3 ) au-dessus et dopée par le premier type de conductivité et une quatrième couche ( S4 ) au-dessus et dopée par le deuxième type de conductivité,
- dans lequel, par des attaques masquées en plusieurs stades de la succession de couches, on produit des structures ( St1, St2, St3, St4 ) à semi-conducteurs sur lesquelles sont formés au moins le premier transistor ( St1 ), le deuxième transistor ( St2 ), le troisième transistor ( St3 ) et le quatrième transistor ( St4 ),
- dans lequel on forme dans la deuxième couche ( S2 ) et dans la troisième couche ( S3 ) des zones de canal, de sorte que des hauteurs, par rapport à un axe y ( y ) qui s'étend perpendiculairement à une surface ( O ) d'un substrat ( 1 ), des zones de canal du troisième transistor ( St3 ) et du quatrième transistor ( St4 ) coïncident entre elles, des hauteurs, par rapport à l'axe y ( y ) de la zone de canal du premier transistor ( St1 ) et du deuxième transistor ( St2 ), coïncident entre elles et la hauteur de la zone de canal du premier transistor ( St1) et la hauteur de la zone de canal du troisième transistor ( St3 ) sont différentes.

10. Procédé suivant la revendication 9,
- dans lequel on produit la première zone de source/drain du premier transistor ( St1 ) et la première zone ( 2 S/D1 ) de source/drain du deuxième transistor ( St2 ) en tant que parties d'une première zone ( Ge1 ) dopée en forme de bande,
- dans lequel on produit la deuxième zone de source/drain du troisième transistor ( St3 ) et la deuxième zone ( 4 S/D2 ) de source/drain du quatrième transistor ( St4 ) en tant que parties d'une deuxième zone ( Ge2 ) dopée en forme de bande,
- dans lequel on forme la deuxième zone de source/drain du cinquième transistor ( St5 ), la deuxième zone de source/drain du sixième transistor ( St6 ), la première ligne ( B1 ) de bits, la deuxième ligne ( B2 ) de bits et la première zone ( Ge1 ) dopée dans la deuxième couche ( S2 ) ou dans la première couche ( S1 ),
- dans lequel on produit la deuxième zone ( Ge2 ) dopée dans la première couche ( S1 ) ou dans la deuxième couche ( S2 ),
- dans lequel on produit la deuxième zone ( Ge2 ) dopée non dans la couche dans laquelle on produit la première zone ( Ge1 ) dopée.

11. Procédé suivant la revendication 9 ou 10,
- dans lequel on dépose une première couche ( H1 ) auxiliaire après la production de la succession de couches,
- dans lequel on produit des sillons s'étendant parallèlement à l'axe z ( z ) dans la première couche ( H1 ) auxiliaire,
- dans lequel on crée des espaceurs ( Sp ) par dépôt et attaque en retrait de matière sur des flancs des sillons,
- dans lequel on attaque à l'aide d'un masque, qui recouvre les parties en forme de bandes et s'étendant parallèlement à la ligne ( W ) de mots en créant ainsi un premier masque ( M1 ) à partir des espaceurs ( Sp ),
- dans lequel on produit à l'aide du premier masque par attaque de la succession de couches au moins les structures ( St1, St2, St3, St4 ) à semi-conducteurs, sur lesquelles sont formés au moins le premier transistor ( St1 ) et le deuxième transistor ( St2 ) ou le troisième transistor ( St3 ) et le quatrième transistor ( St4 ).

12. Procédé suivant l'une des revendications 6 à 11,
- dans lequel on produit pour le premier transistor ( St1 ), le deuxième transistor ( St2 ), le troisième transistor ( St3 ), le quatrième transistor ( St4 ), le cinquième transistor ( St5 ) et le sixième transistor ( St6 ) respectivement au moins une structure ( St1, St2, St3, St4, St5, St6 ) à semi-conducteurs,
- dans lequel, après production d'un diélectrique ( Gd ) de grille, on dépose du matériau conducteur et on l'attaque à l'aide d'un sixième masque qui recouvre des parties comprises entre les transistors, de façon à produire
a ) des électrodes ( Ga1, Ga2, Ga3, Ga4, Ga5, Ga6 ) de grille des transistors, qui entourent les structures ( St1, St2, St3, St4, St5, St6 ) à semi-conducteurs associées,
b ) la première structure ( L1 ) conductrice,
c ) entre le premier transistor ( St1 ) et le deuxième transistor ( St2 ), une deuxième structure ( L2 ) conductrice, qui chevauche une électrode ( Ga2 ) de grille du deuxième transistor ( St2 ),
d) entre le deuxième transistor ( St2 ) et le quatrième transistor ( St4 ), une troisième structure ( L3 ) conductrice, qui chevauche l'électrode ( Ga2 ) de grille du deuxième transistor ( St2 ) et une électrode ( Ga4 ) de grille du quatrième transistor,
e ) entre le troisième transistor ( St3 ) et le quatrième transistor ( St4 ), une quatrième structure ( L4 ) conductrice, qui chevauche une électrode ( Ga3 ) de grille du troisième transistor,
f ) entre le premier transistor ( St1 ) et le troisième transistor ( St3 ), une cinquième structure ( L5 ) conductrice qui chevauche la une électrode ( Ga3 ) de grille du troisième transistor ( St3 ).
